(19) **Europäisches Patentamt / European Patent Office / Office européen des brevets**

(11) **EP 4 346 049 B1**

(12) ## EUROPEAN PATENT SPECIFICATION

(45) Date of publication and mention of the grant of the patent:
**04.02.2026  Bulletin 2026/06**

(21) Application number: **22903357.6**

(22) Date of filing: **05.12.2022**

(51) International Patent Classification (IPC):
**H02J 3/38** (2026.01)    **H02J 13/00** (2026.01)

(52) Cooperative Patent Classification (CPC):
**H02J 3/381; H02J 13/00002;** H02J 2203/20;
H02J 2300/20

(86) International application number:
**PCT/CN2022/136472**

(87) International publication number:
**WO 2023/103935 (15.06.2023 Gazette 2023/24)**

(54) **METHOD AND SYSTEM FOR ESTIMATING VOLTAGE SUPPORT STRENGTH OF NEW ENERGY GRID-CONNECTED SYSTEM, AND STORAGE MEDIUM AND ELECTRONIC DEVICE**

VERFAHREN UND SYSTEM ZUR SCHÄTZUNG DER SPANNUNGSUNTERSTÜTZUNGSSTÄRKE EINES MIT EINEM NEUEN STROMNETZ VERBUNDENEN SYSTEMS SOWIE SPEICHERMEDIUM UND ELEKTRONISCHE VORRICHTUNG

PROCÉDÉ ET SYSTÈME D'ESTIMATION DE FORCE DE SUPPORT DE TENSION D'UN SYSTÈME CONNECTÉ À UN RÉSEAU À NOUVELLE ÉNERGIE, ET SUPPORT DE STOCKAGE ET DISPOSITIF ÉLECTRONIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **10.12.2021  CN 202111502749**

(43) Date of publication of application:
**03.04.2024  Bulletin 2024/14**

(73) Proprietor: **China Electric Power Research Institute**
**Beijing 100192 (CN)**

(72) Inventors:
• **SUN, Huadong**
  **Beijing 100192 (CN)**
• **YU, Lin**
  **Beijing 100192 (CN)**
• **ZHAO, Bing**
  **Beijing 100192 (CN)**

• **XU, Shiyun**
  **Beijing 100192 (CN)**

(74) Representative: **White, Andrew John et al**
**Mathys & Squire**
**The Shard**
**32 London Bridge Street**
**London SE1 9SG (GB)**

(56) References cited:
CN-A- 111 082 450     CN-A- 111 507 572
CN-A- 112 260 326     CN-A- 112 564 175
CN-A- 112 564 175     CN-A- 113 904 375
US-A1- 2019 131 795

• SCHUERGER MATT ET AL: "Catching Some Rays: Variable Generation Integration on the Island of Oahu", IEEE POWER AND ENERGY MAGAZINE, IEEE, USA, vol. 11, no. 6, 1 November 2013 (2013-11-01), pages 33 - 44, XP011530485, ISSN: 1540-7977, [retrieved on 20131016], DOI: 10.1109/MPE.2013.2277998

# EP 4 346 049 B1

**Description**

CROSS-REFERENCE TO RELATED APPLICATIONS

This application is filed based on and claims priority to Chinese Patent application No. 202111502749.2 filed on December 10, 2021 and entitled "METHOD AND SYSTEM FOR ESTIMATING VOLTAGE SUPPORT STRENGTH OF RENEWABLE ENERGY GRID-CONNECTED POWER SYSTEM".

TECHNICAL FIELD

The disclosure relates to the technical field of a stability analysis for grid-connection of a renewable energy, and in particular to a method for estimating a voltage support strength of a renewable energy grid-connected power system, a storage medium and an electronic device.

BACKGROUND

Large-scale developments of renewable energies in China are concentrated in western, northern and other regions. Wind power and photovoltaic units have low voltage regulation capacities, they are easily off-grid due to voltage fluctuations when they are connected to weak power grids, and they require systems to provide voltage support. A short-circuit ratio (SCR) is an important index to judge a voltage support strength of the power system. A critical short-circuit ratio (CSCR) is a short-circuit ratio corresponding to a critical stable state of the power system. By comparing a current SCR of the power system with the CSCR of the power system, an operation state of the power system may be judged, and the voltage support strength of the power system may be estimated, which is helpful to control impacts of grid connections of the renewable energies and is of great significance to ensure a safe and stable operation of a renewable energy grid-connected power system.

At present, as an important index for estimating a voltage support strength of the renewable energy grid-connected power system, the SCR has a contradiction between accuracy and practicability; moreover, calculations of the CSCR are inconsistent due to multiple construction methods, which are difficult to provide an accurate, rapid, intuitive and practical method for estimating the voltage support strength of the renewable energy grid-connected power system.

With respect to the above technical problem that it is difficult to provide an accurate, rapid, intuitive and practical method for estimating the voltage support strength of the renewable energy grid-connected power system in the related art, no effective solution has been proposed at present. A document "Catching Some Rays: Variable Generation Integration on the Island of Oahu", SCHUERGER MATT ET AL, IEEE POWER AND ENERGY MAGAZINE, vol. 11, pages 33-34, XP011530485, and a patent CN 112564175 A provide teachings related to the technical field of the application.

SUMMARY

The invention refers to a method for estimating a voltage support strength of a renewable energy grid-connected power system according to claim 1, a corresponding computer-readable medium according to claim 12, and a corresponding electronic device according to claim 13.

Preferred embodiments are defined in the dependent claims.

With respect to the above technical problem that it is difficult to provide an accurate, rapid, intuitive and practical method for estimating the voltage support strength of the renewable energy grid-connected power system in the related art, the disclosure provides a method for estimating a voltage support strength of a renewable energy grid-connected power system, a storage medium and an electronic device.

The features according to the present invention are defined in the independent claims, and the preferable features according to the present invention are defined in the dependent claims.

According to an aspect of the disclosure, there is provided a method for estimating a voltage support strength of a renewable energy grid-connected power system as set forth in claim 1.

According to yet another aspect of the disclosure, there is provided a computer-readable storage medium as set forth in claim 12.

According to yet another aspect of the disclosure, there is provided an electronic device as set forth in claim 13.

Therefore, according to the disclosure, firstly, the first short-circuit ratio index of the renewable energy grid-connected power system is determined based on the short-circuit capacity provided for the grid connection point by the AC system in the renewable energy grid-connected power system and the equivalent grid connection capacity of the renewable energy at the grid connection point. Then, the second short-circuit ratio index of the renewable energy grid-connected power system is determined based on the voltage variation at the position where the renewable energy is connected to the grid connection point. Secondly, the CSCR of the renewable energy grid-connected power system is determined based on parameters of the AC system and the equivalent maximum transmission power transmitted to the AC system by the renewable energy. Finally, the voltage support strength provided by the renewable energy grid-connected power system at the grid connection point is determined based on the first short-circuit ratio index, the second short-circuit ratio index and the CSCR and by using the preset voltage support strength estimation rule. The disclosure proposes a practical method for calculating the CSCR, by constructing accurate and practical short-circuit ratio indexes, and provides an accurate, rapid, intuitive and practical method and system for estimating the voltage support strength of the renewable energy grid-connected power system, by taking the CSCR as a reference point and taking the short-circuit ratio of the system as a coordinate. Therefore, the disclosure may estimate the voltage support strength of the renewable energy grid-connected power system more intuitively and simply with characteristics of accuracy and rapidity, and the method is simple and practical, which are of great significance to ensure a safe and stable operation of the renewable energy grid-connected power system.

BRIEF DESCRIPTION OF THE DRAWINGS

Exemplary implementations of the disclosure may be understood more completely with reference to the following drawings:

FIG. 1 is a schematic flowchart of a method for estimating a voltage support strength of a renewable energy grid-connected power system according to an embodiment of the disclosure;

FIG. 2 is a schematic diagram of an association relationship among a stable state and strong and weak levels of a renewable energy grid-connected power system, a first short-circuit ratio index, a second short-circuit ratio index and a CSCR according to an embodiment of the disclosure;

FIG. 3 is a schematic structural diagram of a system for estimating a voltage support strength of a renewable energy grid-connected power system according to an exemplary embodiment not being part of the disclosure; and

FIG. 4 is a schematic structural diagram of an electronic device according to an embodiment of the disclosure.

DETAILED DESCRIPTION

Exemplary embodiments of the disclosure will be described in detail below with reference to the drawings. It is apparent that the described embodiments are only part of the embodiments of the disclosure, rather than all of the embodiments of the disclosure. It should be understood that the disclosure is not limited by the exemplary embodiments described here.

It should be noted that relative arrangements, numeric expressions and values of components and operations described in these embodiments do not limit the scope of the disclosure, unless otherwise specified.

It may be understood by those skilled in the art that terms "first", "second" or the like in embodiments of the disclosure are only intended to distinguish different operations, devices, modules, etc., do not represent any particular technical meaning, and do not represent necessary logical orders among the operations, devices, modules, etc.

It should also be understood that in the embodiments of the disclosure, "multiple" may mean two or more, and "at least one" may mean one, two or more.

It should also be understood that any component, data or structure mentioned in the embodiments of the disclosure may be generally understood as one or more component, data or structure, without clear limitations or contrary inspirations given in the context.

Furthermore, a term "and/or" in the disclosure is only an association relationship describing associated objects, and indicates that there may be three relationships. For example, A and/or B may indicate three cases: existence of A alone, existence of A and B simultaneously, and existence of B alone. Furthermore, a character "/" in the disclosure generally indicates that associated objects are in an "or" relationship.

It should also be understood that descriptions of the embodiments of the disclosure emphasize differences among the embodiments, and the same or similar contents of the embodiments may refer to each other and are not elaborated in detail for sake of brevity.

Furthermore, it should be understood that for convenience of descriptions, dimensions of parts shown in the drawings are not drawn according to actual proportional relationships thereof.

Following descriptions of at least one exemplary embodiment are actually only illustrative and do not constitute any limitation on the disclosure and application or usage thereof.

Technologies, methods and devices known to those of ordinary skill in the relevant art may not be discussed in detail, however, the technologies, methods and devices should be considered as part of the specification in an appropriate case.

It should be noted that similar reference symbols and letters represent similar items in the following drawings. Therefore, once an item is defined in one drawing, it does not need to be further discussed in subsequent drawings.

The embodiments of the disclosure may be applied to electronic devices such as terminal devices, computer systems, servers, etc., which may operate with multiple other general-purpose or special-purpose computing systems, environments or configurations. Examples of well-known terminal devices, computing systems, environments and/or configurations suitable to use with the electronic devices such as terminal devices, computer systems, servers, etc. include but are not limited to: personal computer systems, server computer systems, thin clients, thick clients, hand-held or laptop devices, microprocessor-based systems, set-top boxes, programmable consumer electronics, networked personal computers, minicomputer systems, mainframe computer systems, distributed cloud computing technology environments including any of the above systems, etc.

The electronic devices such as terminal devices, computer systems, servers, etc. may be described in a general context of computer system executable instructions (such as program modules) executed by a computer system. Generally, the program modules may include routines, programs, object programs, components, logics, data structures, etc., which perform specific tasks or implement specific types of abstract data. The computer systems/servers may be implemented in a distributed cloud computing environment where tasks are performed by remote processing devices linked through a communication network. In the distributed cloud computing environment, program modules may be located on a storage medium of a local or remote computing system which includes a storage device.

Method

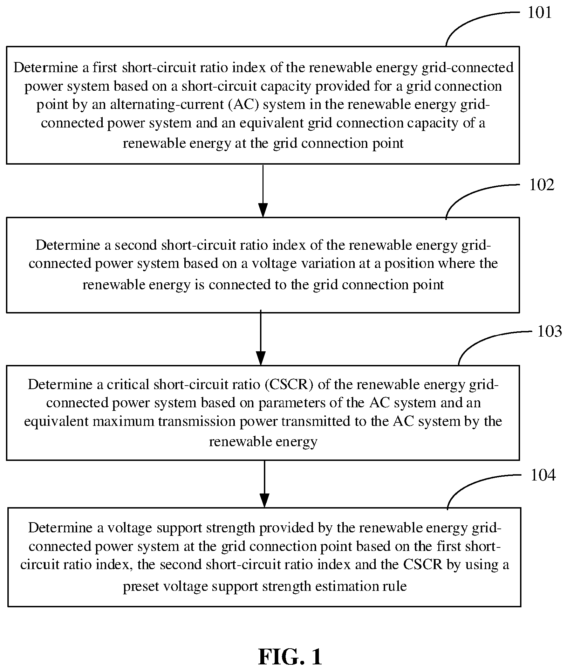

FIG. 1 is a schematic flowchart of a method for estimating a voltage support strength of a renewable energy grid-connected power system according to an embodiment of the disclosure. The embodiment may be applied to an electronic device. As shown in FIG. 1, the method for estimating a voltage support strength of a renewable energy grid-connected power system includes the following operations 101 to 104.

At 101, a first short-circuit ratio index of the renewable energy grid-connected power system is determined based on a short-circuit capacity provided for a grid connection point by an alternating-current (AC) system in the renewable energy grid-connected power system and an equivalent grid connection capacity of a renewable energy at the grid connection point.

In the embodiment of the disclosure, with respect to the renewable energy grid-connected power system, calculating the first short-circuit ratio index SCR-S of the renewable energy grid-connected power system based on capacities is proposed according to a concept of short-circuit ratio and by adopting a ratio of the short-circuit capacity of the AC system to the equivalent grid connection capacity.

In some embodiments, the operation 101 includes the following operations 101a to 101c.

At 101a, the short-circuit capacity provided for the grid connection point by the AC system in the renewable energy grid-connected power system is determined.

In some embodiments, the short-circuit capacity provided for the grid connection point by the AC system is calculated by a formula:

$$\dot{S}_{\mathrm{ac},i} = \frac{U_{\mathrm{N}} \dot{E}_{\mathrm{eq},i}}{\dot{Z}_{ii}}$$

here $\dot{E}_{\mathrm{eq},i}$ is a no-load operation open-circuit voltage of a grid connection point i before total loads in the AC system are not be considered and the renewable energy is grid-connected; $\dot{Z}_{it}$ is a diagonal element in an impedance matrix of the grid connection point, which is an equivalent impedance of the AC system to the grid connection point i; and $U_N$ is a nominal voltage of the grid connection point i.

At 101b, the equivalent grid connection capacity of the renewable energy at the grid connection point is determined.

In some embodiments, the equivalent grid connection capacity of the renewable energy at the grid connection point is calculated by a formula:

$$\dot{S}_{\mathrm{eq},i} = \dot{U}_i \dot{I}_{\mathrm{eq},i}^{*} = \dot{S}_i + \sum_{j \neq i} \frac{\dot{Z}_{ij}^{*}}{\dot{Z}_{ii}^{*}} \frac{\dot{U}_i}{\dot{U}_j} \dot{S}_j$$

here * represents a conjugate operation; $\dot{S}_i$, $\dot{S}_j$ are capacities of renewable energies directly connected to grid connection points i and j; $I_{\text{eq},i}$ is a line current; $\dot{Z}_{ij}$ is a non-diagonal element in an impedance matrix of the grid connection point, which reflects an electrical distance between the grid connection points i and j; $\dot{Z}_{ii}$ is a diagonal element in the impedance matrix of the grid connection point, which is an equivalent impedance of the AC system to the grid connection point i; and $\dot{U}_i$, $\dot{U}_j$ are node voltages of the grid connection points i and j.

At 101c, the first short-circuit ratio index of the renewable energy grid-connected power system is determined based on the short-circuit capacity and the equivalent grid connection capacity.

In some embodiments, the first short-circuit ratio index of the renewable energy grid-connected power system is calculated by a formula:

$$\text{SCR-S}_i = \frac{\dot{S}_{\text{ac},i}}{\dot{S}_{\text{eq},i}} = \frac{\left| U_{\text{N}} \dot{E}_{\text{eq},i} / \dot{Z}_{ii} \right|}{\left| \dot{S}_i + \sum_{j \neq i} \frac{\dot{Z}_{ij}^{*}}{\dot{Z}_{ii}^{*}} \frac{\dot{U}_i}{\dot{U}_j} \dot{S}_j \right|}$$

here $\text{SCR-S}_i$ is the first short-circuit ratio index of the renewable energy grid-connected power system; $\dot{S}_{\text{ac},i}$ is a short-circuit capacity provided for a grid connection point i by the AC system; $\dot{S}_{\text{eq},i}$ is an equivalent grid connection capacity of the renewable energy at the grid connection point i; $\dot{U}_i$, $\dot{U}_j$ are node voltages of grid connection points i and j; $U_N$ is a nominal voltage of the grid connection point i; $\dot{E}_{\text{eq},i}$ is a no-load operation open-circuit voltage of the grid connection point i before total loads in the AC system are not be considered and the renewable energy is grid-connected; $\dot{Z}_{ii}$ is a diagonal element in an impedance matrix of the grid connection point, which is an equivalent impedance of the AC system to the grid connection point i; $\dot{Z}_{ij}$ is a non-diagonal element in the impedance matrix of the grid connection point, which reflects an electrical distance between the grid connection points i and j; and $\dot{S}_i$, $\dot{S}_j$ are capacities of renewable energies directly connected to the grid connection points i and j.

At 102, a second short-circuit ratio index of the renewable energy grid-connected power system is determined based on a voltage variation at a position where the renewable energy is connected to the grid connection point.

In some embodiments, the operation 102 includes the following operations 102a to 102d.

At 102a, a voltage order-reduction equation of the grid connection point is determined when the renewable energy is connected to the grid connection point.

In some embodiments, the voltage order-reduction equation of the grid connection point is:

$$\begin{bmatrix} \Delta \dot{U}_1 \\ \vdots \\ \Delta \dot{U}_i \\ \vdots \\ \Delta \dot{U}_m \end{bmatrix} = \begin{bmatrix} \dot{Z}_{11} & \cdots \dot{Z}_{1i} \cdots & \dot{Z}_{1m} \\ \vdots & \vdots & \vdots \\ \dot{Z}_{i1} & \cdots \dot{Z}_{ii} \cdots & \dot{Z}_{im} \\ \vdots & \vdots & \vdots \\ \dot{Z}_{m1} & \cdots \dot{Z}_{mi} \cdots & \dot{Z}_{mm} \end{bmatrix} \begin{bmatrix} \dot{I}_{\text{E},1} \\ \vdots \\ \dot{I}_{\text{E},i} \\ \vdots \\ \dot{I}_{\text{E},m} \end{bmatrix}$$

here $\dot{Z}$ is an impedance matrix of the grid connection point; $\Delta \dot{U}$ is a voltage variation at the grid connection point caused when the renewable energy is grid-connected; $\dot{I}_{\text{E}}$ is a current injected by the renewable energy; and m is a serial number of the grid connection point.

At 102b, the voltage variation at the position where the renewable energy is connected to the grid connection point, is determined based on the voltage order-reduction equation.

In some embodiments, the voltage variation at the position where the renewable energy is connected to the grid connection point is calculated by a formula:

$$\Delta \dot{U}_i = \dot{Z}_{ii} \dot{I}_{\text{E},i} + \sum_{j \neq i} \dot{Z}_{ij} \dot{I}_{\text{E},j}$$

here $\Delta \dot{U}_i$ is a voltage variation of the grid connection point i; $\dot{I}_{\text{E},i}$, $\dot{I}_{\text{E},j}$ are currents injected by the renewable energy into grid connection points i, j; $\dot{Z}_{ii}$ is a diagonal element in an impedance matrix of the grid connection point, which is an equivalent impedance of the AC system to the grid connection point i; and $\dot{Z}_{ij}$ is a non-diagonal element in the impedance matrix of the grid connection point, which reflects an electrical distance between the grid connection points i and j.

At 102c, a nominal voltage $U_N$ of the grid connection point is determined.

At 102d, the second short-circuit ratio index of the renewable energy grid-connected power system is determined based on the voltage variation and the nominal voltage.

In the embodiment of the disclosure, at 102d, a formula of calculating a ratio of the nominal voltage to the voltage variation is determined first.

Here the ratio of the nominal voltage to the voltage variation is calculated by a formula:

$$\frac{|U_N|}{|\Delta \dot{U}_i|} = \frac{|U_N|}{\left| \dot{Z}_{ii} \dot{I}_{E,i} + \sum_{j \neq i} \dot{Z}_{ij} \dot{I}_{E,j} \right|}$$

here $U_N$ is a nominal voltage of the grid connection point i; $\Delta \dot{U}_i$ is the voltage variation of the grid connection point i; $\dot{I}_{E,i}$, $\dot{I}_{E,j}$ are the currents injected by the renewable energy into the grid connection points i, j; $\dot{Z}_{ii}$ is the diagonal element in the impedance matrix of the grid connection point, which is the equivalent impedance of the AC system to the grid connection point i; and $\dot{Z}_{ij}$ is the non-diagonal element in the impedance matrix of the grid connection point, which reflects the electrical distance between the grid connection points i and j.

Then, the formula of calculating the ratio of the nominal voltage to the voltage variation is further derived, and the second short-circuit ratio index of the renewable energy grid-connected power system is determined. Here the second short-circuit ratio index of the renewable energy grid-connected power system is calculated by a formula:

$$\text{SCR-U}_i = \frac{|U_N \dot{E}_{eq,i}|}{|\Delta \dot{U}_i \dot{U}_i|}$$

here SCR-U$_i$ is the second short-circuit ratio index of the renewable energy grid-connected power system; $U_N$ is the nominal voltage of the grid connection point i; $\dot{E}_{eq,i}$ is a no-load operation open-circuit voltage of the grid connection point i before total loads in the AC system are not be considered and the renewable energy is grid-connected; $\Delta \dot{U}_i$ is the voltage variation of the grid connection point i; and $\dot{U}_i$ is a node voltage of the grid connection point i.

At 103, a critical short-circuit ratio (CSCR) of the renewable energy grid-connected power system is determined based on parameters of the AC system and an equivalent maximum transmission power transmitted to the AC system by the renewable energy.

In some embodiments, the operation 103 includes the following operations 103a to 103d.

At 103a, a transmission power transmitted to the AC system by the renewable energy is determined, here the transmission power is calculated by a formula:

$$\dot{S}_{eq,i} = (U_i \cos\theta_i + jU_i \sin\theta_i)\left(\frac{U_i \cos\theta_i + jU_i \sin\theta_i - E_{eq,i}}{R_{eq,i} + jX_{eq,i}}\right)^*$$

$$\begin{cases} P_{eq,i} = \dfrac{U_i^2 R_{eq,i} - U_i E_{eq,i} R_{eq,i} \cos\theta_i + U_i E_{eq,i} X_{eq,i} \sin\theta_i}{R_{eq,i}^2 + X_{eq,i}^2} \\[4mm] Q_{eq,i} = \dfrac{U_i^2 X_{eq,i} - U_i E_{eq,i} X_{eq,i} \cos\theta_i - U_i E_{eq,i} R_{eq,i} \sin\theta_i}{R_{eq,i}^2 + X_{eq,i}^2} \end{cases}$$

here $\dot{S}_{eq,i}$ is an equivalent grid connection capacity of the renewable energy at a grid connection point i; $P_{eq,i}$, $Q_{eq,i}$ are an equivalent active power and an equivalent reactive power transmitted to the AC system by the renewable energy respectively; $E_{eq,i}$ is an equivalent potential of the AC system; $R_{eq,i}$ is a Thevenin equivalent resistance of the AC system, and $X_{eq,i}$ is a Thevenin equivalent reactance of the AC system; $U_i$ is a bus voltage of grid connection of the renewable energy; $\theta_i$ is a difference between a phase angle of the bus voltage and a phase angle of the equivalent potential; and j is an imaginary number.

At 103b, a one-variable quadratic equation about $U_i^2$ is established according to a trigonometric function $\sin^2\theta_i + \cos^2\theta_i = 1$:

$$U_i^4 - [2(P_{eq,i}R_{eq,i} + Q_{eq,i}X_{eq,i}) + E_{eq,i}^2]U_i^2 + (R_{eq,i}^2 + X_{eq,i}^2)(P_{eq,i}^2 + Q_{eq,i}^2) = 0$$

$$\begin{cases} \lambda = \dfrac{R_{eq,i}P_{eq,i} + X_{eq,i}Q_{eq,i}}{E_{eq,i}^2} \\[4mm] \mu = \dfrac{X_{eq,i}P_{eq,i} - R_{eq,i}Q_{eq,i}}{E_{eq,i}^2} \end{cases}$$

$$\Delta = 1 + 4(\lambda - \mu^2) = 0$$

here $\lambda$, $\mu$ are sensitivity factors, and $\Delta$ is a discriminant of the equation.

At 103c, the transmission power transmitted to the AC system by the renewable energy is set to be the equivalent maximum transmission power when $\Delta=0$, here the equivalent maximum transmission power is calculated by a formula:

$$P_{eq,i\max} = \frac{R_{eq,i}\left(E_{eq,i}^2 + 2Q_{eq,i}X_{eq,i}\right) + E_{eq,i}\sqrt{R_{eq,i}^2 + X_{eq,i}^2}\sqrt{E_{eq,i}^2 + 4Q_{eq,i}X_{eq,i}}}{2X_{eq,i}^2}$$

here $P_{eq,i\max}$ is the equivalent maximum transmission power transmitted to the AC system by the renewable energy, $Q_{eq,i}$ is the equivalent reactive power transmitted to the AC system by the renewable energy, $E_{eq,i}$ is the equivalent potential of the AC system; $R_{eq,i}$ is the Thevenin equivalent resistance of the AC system, and $X_{eq,i}$ is the Thevenin equivalent reactance of the AC system.

At 103d, the CSCR of the renewable energy grid-connected power system is determined, by:

$$CSCR = \frac{\dot{S}_{ac,i}}{\left| P_{eq,i\max} + jQ_{eq,i} \right|}$$

here $\dot{S}_{ac,i}$ is a short-circuit capacity provided for the grid connection point i by the AC system; $Q_{eq,i}$ is the equivalent reactive power transmitted to the AC system by the renewable energy; $P_{eq,i\max}$ is the equivalent maximum transmission power transmitted to the AC system by the renewable energy; and j is the imaginary number.

In the embodiment of the disclosure, the parameters of the AC system include the equivalent potential $E_{eq,i}$ of the AC system, the Thevenin equivalent resistance $R_{eq,i}$ of the AC system, and the Thevenin equivalent reactance $X_{eq,i}$ of the AC system.

At 104, a voltage support strength provided by the renewable energy grid-connected power system at the grid connection point is determined based on the first short-circuit ratio index, the second short-circuit ratio index and the CSCR and by using a preset voltage support strength estimation rule.

In the embodiment of the disclosure, the preset voltage support strength estimation rule is as follows:

1) It is determined that an abstract concept of the voltage support strength of the renewable energy grid-connected power system exists with reference to a standard for dividing strong and weak levels of the renewable energy grid-connected power system, estimation of the voltage support strength of the renewable energy grid-connected power system is implemented by taking the CSCR of grid connection of the renewable energy as a reference point and taking the short-circuit ratio index of grid connection of the renewable energy as a coordinate.

2) It is determined that two short-circuit ratio indexes with the same estimation effect are constructed for the renewable energy grid-connected power system: SCR-S (corresponding to the first short-circuit ratio index) and SCR-U (corresponding to the second short-circuit ratio index).

3) It is determined that a stable state of the renewable energy grid-connected power system is determined by comparing the short-circuit ratio indexes of the renewable energy grid-connected power system with the CSCR. When the renewable energy grid-connected power system does not reach a critical stability, there is a distance between the short-circuit ratio index and the CSCR, and the renewable energy grid-connected power system has a safety margin.

That is:

3.1) when SCR-U (or SCR-S) is greater than the CSCR (corresponding to the critical short-circuit ratio), the renewable energy grid-connected power system operates in a stable region of P-V characteristics and the renewable energy grid-connected power system is in a stable state;

3.2) when SCR-U (or SCR-S) is less than the CSCR (corresponding to the critical short-circuit ratio), the renewable energy grid-connected power system operates in an unstable region of the P-V characteristics and the renewable energy grid-connected power system is in an unstable state.

4) It is determined that strong and weak levels of the renewable energy grid-connected power system is determined by calculating the short-circuit ratio indexes of the renewable energy grid-connected power system and comparing the short-circuit ratio indexes with the standard for dividing strong and weak levels of the renewable energy grid-connected power system. Here strong level of the renewable energy grid-connected power system means a strong voltage support level provided by the renewable energy grid-connected power system at the grid connection point, and weak level of the renewable energy grid-connected power system means a weak voltage support level provided by the renewable energy grid-connected power system at the grid connection point.

4.1) When the short-circuit ratio index (SCR-U or SCR-S) is greater than 2, the renewable energy grid-connected power system is a strong system;

4.2) When the short-circuit ratio index (SCR-U or SCR-S) is less than 2, the renewable energy grid-connected power system is a weak system.

In some embodiments, the operation 104 includes the following operations 104a to 104d.

At 104a, an extreme value of the CSCR of the renewable energy grid-connected power system is determined when active power and reactive power of the renewable energy grid-connected power system flow from the renewable energy into the AC system.

In the embodiment of the disclosure, it may be known by referring to the formula of calculating the CSCR of the renewable energy grid-connected power system that when the active power and reactive power of the renewable energy grid-connected power system flow from the renewable energy into the AC system, the CSCR of the renewable energy grid-connected power system has a maximum value of 2 (corresponding to the extreme value).

At 104b, the extreme value of the CSCR is determined as a standard for dividing strong and weak voltage support levels of the renewable energy grid-connected power system.

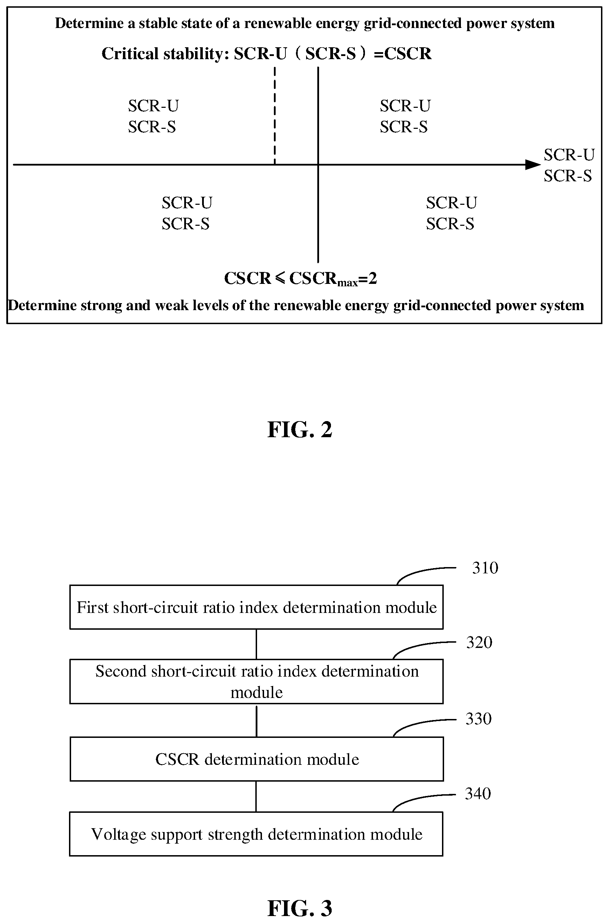

In the embodiment of the disclosure, as shown in FIG. 2, the extreme value of 2 of the CSCR is taken as a standard for dividing strong and weak levels of the renewable energy grid-connected power system. Here strong level of the renewable energy grid-connected power system means a strong voltage support level provided by the renewable energy grid-connected power system at the grid connection point, and weak level of the renewable energy grid-connected power system means a weak voltage support level provided by the renewable energy grid-connected power system at the grid connection point.

At 104c, the strong voltage support level of the renewable energy grid-connected power system is determined when the first short-circuit ratio index or the second short-circuit ratio index is greater than the extreme value of the CSCR.

At 104d, the weak voltage support level of the renewable energy grid-connected power system is determined when the first short-circuit ratio index or the second short-circuit ratio index is less than the extreme value of the CSCR.

In some embodiments, the method further includes the following operations. A stable state of the renewable energy grid-connected power system is determined based on the first short-circuit ratio index, the second short-circuit ratio index and the CSCR.

In some embodiments, as shown in FIG. 2, the operation of determining the stable state of the renewable energy grid-connected power system based on the first short-circuit ratio index, the second short-circuit ratio index and the CSCR includes the following operations.

1) It is determined that the renewable energy grid-connected power system operates in a stable region of P-V characteristics and the renewable energy grid-connected power system is in a stable state, when the first short-circuit ratio index or the second short-circuit ratio index is greater than the CSCR.

2) It is determined that the renewable energy grid-connected power system operates in an unstable region of the P-V characteristics and the renewable energy grid-connected power system is in an unstable state, when the first short-circuit ratio index or the second short-circuit ratio index is less than the CSCR.

Therefore, according to the disclosure, firstly, the first short-circuit ratio index of the renewable energy grid-connected power system is determined based on the short-circuit capacity provided for the grid connection point by the AC system in the renewable energy grid-connected power system and the equivalent grid connection capacity of the renewable energy at the grid connection point. Then, the second short-circuit ratio index of the renewable energy grid-connected power system is determined based on the voltage variation at the position where the renewable energy is connected to the grid connection point. Secondly, the CSCR of the renewable energy grid-connected power system is determined based on parameters of the AC system and the equivalent maximum transmission power transmitted to the AC system by the renewable energy. Finally, the voltage support strength provided by the renewable energy grid-connected power system at the grid connection point is determined based on the first short-circuit ratio index, the second short-circuit ratio index and the CSCR and by using the preset voltage support strength estimation rule. The disclosure proposes a practical method for calculating the CSCR, by constructing accurate and practical short-circuit ratio indexes, and provides an accurate, rapid, intuitive and practical method and system for estimating the voltage support strength of the renewable energy grid-connected power system, by taking the CSCR as a reference point and taking the short-circuit ratio of the system as a coordinate. Therefore, the disclosure may estimate the voltage support strength of the renewable energy grid-connected power system more intuitively and simply with characteristics of accuracy and rapidity, and the method is simple and practical, which are of great significance to ensure a safe and stable operation of the renewable energy grid-connected power system.

Exemplary system

FIG. 3 is a schematic structural diagram of a system for estimating a voltage support strength of a renewable energy grid-connected power system according to an exemplary embodiment not being part of the disclosure. As shown in FIG. 3, the system includes a first short-circuit ratio index determination module 310, a second short-circuit ratio index determination module 320, a CSCR determination module 330, and a voltage support strength determination module 340.

The first short-circuit ratio index determination module 310 is configured to determine a first short-circuit ratio index of the renewable energy grid-connected power system based on a short-circuit capacity provided for a grid connection point by an AC system in the renewable energy grid-connected power system and an equivalent grid connection capacity of a renewable energy at the grid connection point.

The second short-circuit ratio index determination module 320 is configured to determine a second short-circuit ratio index of the renewable energy grid-connected power system based on a voltage variation at a position where the renewable energy is connected to the grid connection point.

The CSCR determination module 330 is configured to determine a CSCR of the renewable energy grid-connected power system based on parameters of the AC system and an equivalent maximum transmission power transmitted to the AC system by the renewable energy.

The voltage support strength determination module 340 is configured to determine a voltage support strength provided by the renewable energy grid-connected power system at the grid connection point based on the first short-circuit ratio index, the second short-circuit ratio index and the CSCR and by using a preset voltage support strength estimation rule.

In the disclosure, the first short-circuit ratio index determination module 310 is specifically configured to:

determine the short-circuit capacity provided for the grid connection point by the AC system in the renewable energy grid-connected power system;

determine the equivalent grid connection capacity of the renewable energy at the grid connection point; and

determine the first short-circuit ratio index of the renewable energy grid-connected power system based on the short-circuit capacity and the equivalent grid connection capacity.

In the disclosure, the short-circuit capacity provided for the grid connection point by the AC system is calculated by a formula:

$$\dot{S}_{\text{ac},i} = \frac{U_{\text{N}} \dot{E}_{\text{eq},i}}{\dot{Z}_{ii}}$$

here $\dot{E}_{\text{eq},i}$ is a no-load operation open-circuit voltage of a grid connection point i before total loads in the AC system are not be considered and the renewable energy is grid-connected; $\dot{Z}_{ii}$ is a diagonal element in an impedance matrix of the grid connection point, which is an equivalent impedance of the AC system to the grid connection point i; and $U_N$ is a nominal voltage of the grid connection point i.

In the disclosure, the equivalent grid connection capacity at the grid connection point is calculated by a formula:

$$\dot{S}_{\mathrm{eq},i} = \dot{U}_i I_{\mathrm{eq},i}^* = \dot{S}_i + \sum_{j \neq i} \frac{\dot{Z}_{ij}^*}{\dot{Z}_{ii}^*} \frac{\dot{U}_i}{\dot{U}_j} \dot{S}_j$$

here * represents a conjugate operation; $\dot{S}_i$, $\dot{S}_j$ are capacities of renewable energies directly connected to grid connection points i and j; $I_{\mathrm{eq},i}$ is a line current; $\dot{Z}_{ij}$ is a non-diagonal element in an impedance matrix of the grid connection point, which reflects an electrical distance between the grid connection points i and j; $\dot{Z}_{ii}$ is a diagonal element in the impedance matrix of the grid connection point, which is an equivalent impedance of the AC system to the grid connection point i; and $\dot{U}_i$, $\dot{U}_j$ are node voltages of the grid connection points i and j.

In the disclosure, the first short-circuit ratio index of the renewable energy grid-connected power system is calculated by a formula:

$$\mathrm{SCR\text{-}S}_i = \frac{\dot{S}_{\mathrm{ac},i}}{\dot{S}_{\mathrm{eq},i}} = \frac{\left| U_{\mathrm{N}} \dot{E}_{\mathrm{eq},i} / \dot{Z}_{ii} \right|}{\left| \dot{S}_i + \sum_{j \neq i} \frac{\dot{Z}_{ij}^*}{\dot{Z}_{ii}^*} \frac{\dot{U}_i}{\dot{U}_j} \dot{S}_j \right|}$$

here SCR-S$_i$ is the first short-circuit ratio index of the renewable energy grid-connected power system; $\dot{S}_{\mathrm{ac},i}$ is a short-circuit capacity provided for a grid connection point i by the AC system; $\dot{S}_{\mathrm{eq},i}$ is an equivalent grid connection capacity of the renewable energy at the grid connection point i; $\dot{U}_i$, $\dot{U}_j$ are node voltages of grid connection points i and j; $U_N$ is a nominal voltage of the grid connection point i; $\dot{E}_{\mathrm{eq},i}$ is a no-load operation open-circuit voltage of the grid connection point i before total loads in the AC system are not be considered and the renewable energy is grid-connected; $\dot{Z}_{ii}$ is a diagonal element in an impedance matrix of the grid connection point, which is an equivalent impedance of the AC system to the grid connection point i; $\dot{Z}_{ij}$ is a non-diagonal element in the impedance matrix of the grid connection point, which reflects an electrical distance between the grid connection points i and j; and $\dot{S}_i$, $\dot{S}_j$ are capacities of renewable energies directly connected to the grid connection points i and j.

In the disclosure, the second short-circuit ratio index determination module 320 is specifically configured to:

determine a voltage order-reduction equation of the grid connection point when the renewable energy is connected to the grid connection point;
determine the voltage variation at the position where the renewable energy is connected to the grid connection point based on the voltage order-reduction equation;
determine a nominal voltage of the grid connection point; and
determine the second short-circuit ratio index of the renewable energy grid-connected power system based on the voltage variation and the nominal voltage.

In the disclosure, the voltage order-reduction equation of the grid connection point is:

$$\begin{bmatrix} \Delta\dot{U}_1 \\ \vdots \\ \Delta\dot{U}_i \\ \vdots \\ \Delta\dot{U}_m \end{bmatrix} = \begin{bmatrix} \dot{Z}_{11} & \cdots \dot{Z}_{1i} & \cdots \dot{Z}_{1m} \\ \vdots & \vdots & \vdots \\ \dot{Z}_{i1} & \cdots \dot{Z}_{ii} & \cdots \dot{Z}_{im} \\ \vdots & \vdots & \vdots \\ \dot{Z}_{m1} & \cdots \dot{Z}_{mi} & \cdots \dot{Z}_{mm} \end{bmatrix} \begin{bmatrix} \dot{I}_{\mathrm{E},1} \\ \vdots \\ \dot{I}_{\mathrm{E},i} \\ \vdots \\ \dot{I}_{\mathrm{E},m} \end{bmatrix}$$

here $\dot{Z}$ is an impedance matrix of the grid connection point; $\Delta\dot{U}$ is a voltage variation at the grid connection point caused when the renewable energy is grid-connected; $\dot{I}_{\mathrm{E}}$ is a current injected by the renewable energy; and m is a serial number of the grid connection point.

In the disclosure, the voltage variation at the position where the renewable energy is connected to the grid connection point is calculated by a formula:

$$\Delta \dot{U}_i = \dot{Z}_{ii} \dot{I}_{E,i} + \sum_{j \neq i} \dot{Z}_{ij} \dot{I}_{E,j}$$

here $\Delta \dot{U}_i$ is a voltage variation of the grid connection point i; $\dot{I}_{E,i}$, $\dot{I}_{E,j}$ are currents injected by the renewable energy into grid connection points i, j; $\dot{Z}_{ii}$ is a diagonal element in an impedance matrix of the grid connection point, which is an equivalent impedance of the AC system to the grid connection point i; and $\dot{Z}_{ij}$ is a non-diagonal element in the impedance matrix of the grid connection point, which reflects an electrical distance between the grid connection points i and j.

In the disclosure, the second short-circuit ratio index determination module 320 is specifically configured to:

determine a formula of calculating a ratio of the nominal voltage to the voltage variation; and

further derive the formula of calculating the ratio of the nominal voltage to the voltage variation, and determine the second short-circuit ratio index of the renewable energy grid-connected power system,

here the ratio of the nominal voltage to the voltage variation is calculated by a formula:

$$\frac{|U_N|}{|\Delta \dot{U}_i|} = \frac{|U_N|}{\left| \dot{Z}_{i} \dot{I}_{E,i} + \sum_{j \neq i} \dot{Z}_{ij} \dot{I}_{E,j} \right|}$$

here $U_N$ is a nominal voltage of the grid connection point; $\Delta \dot{U}_i$ is the voltage variation of the grid connection point i; $\dot{I}_{E,i}$, $\dot{I}_{E,j}$ are the currents injected by the renewable energy into the grid connection points i, j; $\dot{Z}_{ii}$ is the diagonal element in the impedance matrix of the grid connection point, which is the equivalent impedance of the AC system to the grid connection point i; and $\dot{Z}_{ij}$ is the non-diagonal element in the impedance matrix of the grid connection point, which reflects the electrical distance between the grid connection points i and j.

The second short-circuit ratio index of the renewable energy grid-connected power system is calculated by a formula:

$$\text{SCR-U}_i = \frac{|U_N \dot{E}_{eq,i}|}{|\Delta \dot{U}_i \dot{U}_i|}$$

here SCR-U$_i$ is the second short-circuit ratio index of the renewable energy grid-connected power system; $U_N$ is the nominal voltage of the grid connection point i; $\dot{E}_{eq,i}$ is a no-load operation open-circuit voltage of the grid connection point i before total loads in the AC system are not be considered and the renewable energy is grid-connected; $\Delta \dot{U}_i$ is the voltage variation of the grid connection point i; and $\dot{U}_i$ is a node voltage of the grid connection point i.

In the disclosure, the CSCR determination module 330 is specifically configured to:

determine a transmission power transmitted to the AC system by the renewable energy, here the transmission power is calculated by a formula:

$$\dot{S}_{eq,i} = (U_i \cos\theta_i + jU_i \sin\theta_i)\left(\frac{U_i \cos\theta_i + jU_i \sin\theta_i - E_{eq,i}}{R_{eq,i} + jX_{eq,i}}\right)^*$$

$$\begin{cases} P_{eq,i} = \dfrac{U_i^2 R_{eq,i} - U_i E_{eq,i} R_{eq,i} \cos\theta_i + U_i E_{eq,i} X_{eq,i} \sin\theta_i}{R_{eq,i}^2 + X_{eq,i}^2} \\[4mm] Q_{eq,i} = \dfrac{U_i^2 X_{eq,i} - U_i E_{eq,i} X_{eq,i} \cos\theta_i - U_i E_{eq,i} R_{eq,i} \sin\theta_i}{R_{eq,i}^2 + X_{eq,i}^2} \end{cases}$$

here $\dot{S}_{eq,i}$ is an equivalent grid connection capacity of the renewable energy at a grid connection point i; $P_{eq,i}$, $Q_{eq,i}$ are an equivalent active power and an equivalent reactive power transmitted to the AC system by the renewable energy respectively; $E_{eq,i}$ is an equivalent potential of the AC system; $R_{eq,i}$ is a Thevenin equivalent resistance of the AC system, and $X_{eq,i}$ is a Thevenin equivalent reactance of the AC system; $U_i$ is a bus voltage of grid connection of the renewable energy; $\theta_i$ is a difference between a phase angle of the bus voltage and a phase angle of the equivalent potential; and j is an imaginary number;

establish a one-variable quadratic equation about $U_i^2$ according to a trigonometric function $\sin^2\theta_i + \cos^2\theta_i = 1$:

$$U_i^4 - [2(P_{eq,i}R_{eq,i} + Q_{eq,i}X_{eq,i}) + E_{eq,i}^2]U_i^2 + (R_{eq,i}^2 + X_{eq,i}^2)(P_{eq,i}^2 + Q_{eq,i}^2) = 0$$

$$\begin{cases} \lambda = \dfrac{R_{eq,i}P_{eq,i} + X_{eq,i}Q_{eq,i}}{E_{eq,i}^2} \\[4mm] \mu = \dfrac{X_{eq,i}P_{eq,i} - R_{eq,i}Q_{eq,i}}{E_{eq,i}^2} \end{cases}$$

$$\Delta = 1 + 4(\lambda - \mu^2) = 0$$

here $\lambda$, $\mu$ are sensitivity factors, and $\Delta$ is a discriminant of the equation;

set the transmission power transmitted to the AC system by the renewable energy to be the equivalent maximum transmission power when $\Delta = 0$, here the equivalent maximum transmission power is calculated by a formula:

$$P_{eq,i\max} = \frac{R_{eq,i}\left(E_{eq,i}^2 + 2Q_{eq,i}X_{eq,i}\right) + E_{eq,i}\sqrt{R_{eq,i}^2 + X_{eq,i}^2}\sqrt{E_{eq,i}^2 + 4Q_{eq,i}X_{eq,i}}}{2X_{eq,i}^2}$$

here $P_{eq,imax}$ is the equivalent maximum transmission power transmitted to the AC system by the renewable energy, $Q_{eq,i}$ is the equivalent reactive power transmitted to the AC system by the renewable energy, $E_{eq,i}$ is the equivalent potential of the AC system; $R_{eq,i}$ is the Thevenin equivalent resistance of the AC system, and $X_{eq,i}$ is the Thevenin equivalent reactance of the AC system; and

determine the CSCR of the renewable energy grid-connected power system, by:

$$\text{CSCR} = \frac{\dot{S}_{ac,i}}{\left|P_{eq,i\max} + jQ_{eq,i}\right|}$$

here $\dot{S}_{ac,i}$ is a short-circuit capacity provided for the grid connection point i by the AC system; $Q_{eq,i}$ is the equivalent reactive power transmitted to the AC system by the renewable energy; $P_{eq,imax}$ is the equivalent maximum transmission power transmitted to the AC system by the renewable energy; and j is the imaginary number.

In the disclosure, the voltage support strength determination module 340 is specifically configured to:

determine an extreme value of the CSCR of the renewable energy grid-connected power system when active power and reactive power of the renewable energy grid-connected power system flow from the renewable energy into the AC system;

determine the extreme value of the CSCR as a standard for dividing strong and weak voltage support levels of the renewable energy grid-connected power system;

determine the strong voltage support level of the renewable energy grid-connected power system when the first short-circuit ratio index or the second short-circuit ratio index is greater than the extreme value of the CSCR; and

determine the weak voltage support level of the renewable energy grid-connected power system when the first short-circuit ratio index or the second short-circuit ratio index is less than the extreme value of the CSCR.

In the disclosure, the voltage support strength determination module 340 is further specifically configured to determine a stable state of the renewable energy grid-connected power system based on the first short-circuit ratio index, the second short-circuit ratio index and the CSCR.

In the disclosure, the voltage support strength determination module 340 is further specifically configured to:

determine that the renewable energy grid-connected power system operates in a stable region of P-V characteristics and the renewable energy grid-connected power system is in a stable state, when the first short-circuit ratio index or the second short-circuit ratio index is greater than the CSCR; and

determine that the renewable energy grid-connected power system operates in an unstable region of the P-V characteristics and the renewable energy grid-connected power system is in an unstable state, when the first short-circuit ratio index or the second short-circuit ratio index is less than the CSCR.

The system 300 for estimating a voltage support strength of a renewable energy grid-connected power system according to the disclosure corresponds to the method 100 for estimating a voltage support strength of a renewable energy grid-connected power system according to the embodiments of the disclosure, and is not elaborated here.

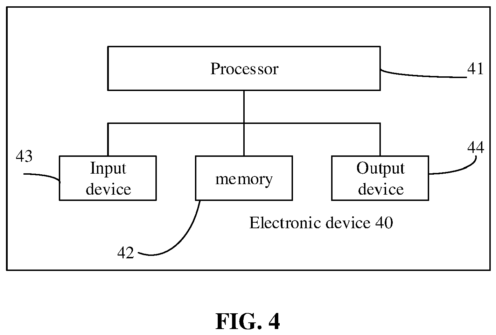

FIG. 4 is a schematic structural diagram of an electronic device according to an embodiment of the disclosure. As shown in FIG. 4, the electronic device 40 includes one or more processors 41 and a memory 42.

The processor 41 may be a central processing unit (CPU) or other forms of processing units with data processing capability and/or instruction execution capability, and may control other components in the electronic device to perform desired functions.

The memory 42 may include one or more computer program products which may include various forms of computer-readable storage mediums, such as a volatile memory and/or a non-volatile memory. For example, the volatile memory may include a random access memory (RAM), and/or a cache memory (cache), or the like. For example, the non-volatile memory may include a read-only memory (ROM), a hard disk, a flash memory, or the like. One or more computer program instructions may be stored on the computer-readable storage medium, and the processor 41 may execute the program instructions to implement the method for information mining of historical change records and/or other desired functions of software programs of various embodiments of the disclosure described above. In an example, the electronic device may further include an input device 43 and an output device 44 which are interconnected by a bus system and/or other forms of connection mechanisms (not shown).

Furthermore, for example, the input device 43 may further include a keyboard, a mouse, or the like.

The output device 44 may output various information to the outside. For example, the output device 44 may include a display, a speaker, a printer, a communication network and remote output devices connected thereto, or the like.

Of course, for sake of simplicity, only some of components in the electronic device related to the disclosure are shown in FIG. 4, and components such as a bus, an input/output interface, or the like are omitted. In addition, the electronic device may further include any other suitable components according to a specific application.

Computer program product and computer-readable storage medium

In addition to the above methods and devices, the disclosure may be a computer program product which includes computer program instructions, the computer program instructions enable a processor to execute operations of the method for information mining of historical change records according to various embodiments of the disclosure and described in the above "Method" section of the description when the computer program instructions are executed by the processor.

The computer program product may write program codes configured to perform operations of the embodiments of the disclosure in any combination of one or more programming languages which include object-oriented programming languages such as Java, C++, etc., and conventional procedural programming languages such as "C" language or similar programming languages. The program codes may be completely executed on a user computing device, partly executed on a user device, executed as a separate software package, partly executed on the user computing device and partly executed on a remote computing device, or completely executed on the remote computing device or a server.

Furthermore, the embodiments of the disclosure are a computer-readable storage medium, having stored thereon computer program instructions, the computer program instructions enable a processor to execute operations of the method for information mining of historical change records according to various embodiments of the disclosure and described in the above "Method" section of the description when the computer program instructions are executed by the processor.

The computer-readable storage medium may adopt any combination of one or more readable mediums. The readable medium may be a readable signal medium or a readable storage medium. For example, the readable storage medium may include, but is not limited to electric, magnetic, optical, electromagnetic, infrared or semiconductor systems, systems or devices, or any combination of the above items. More specific examples (a non-exhaustive list) of the readable storage medium include an electrical connection with one or more wires, a portable disk, a hard disk, a RAM, a ROM, an erasable programmable ROM (EPROM or a flash memory), an optical fiber, a portable compact disk ROM (CD-ROM), an optical storage device, a magnetic storage device, or any suitable combination of the above items.

The method and system of the disclosure may be implemented in many ways. For example, the method and system of the disclosure may be implemented through software, hardware, firmware, or any combination of software, hardware and firmware. The above sequences for operations of the method are only for illustration, and the operations of the method according to the disclosure are not limited to the above specific sequences, unless otherwise specified in other ways. Furthermore, in some embodiments, the disclosure may also be implemented as programs recorded in a recording medium, and these programs include machine-readable instructions for implementing the method according to the disclosure. Therefore, the disclosure also covers a recording medium which stores programs for executing the method according to the disclosure.

INDUSTRIAL APPLICABILITY

According to the disclosure, firstly, the first short-circuit ratio index of the renewable energy grid-connected power system is determined based on the short-circuit capacity provided for the grid connection point by the AC system in the renewable energy grid-connected power system and the equivalent grid connection capacity of the renewable energy at the grid connection point. Then, the second short-circuit ratio index of the renewable energy grid-connected power system is determined based on the voltage variation at the position where the renewable energy is connected to the grid connection point. Secondly, the CSCR of the renewable energy grid-connected power system is determined based on parameters of the AC system and the equivalent maximum transmission power transmitted to the AC system by the renewable energy. Finally, the voltage support strength provided by the renewable energy grid-connected power system at the grid connection point is determined based on the first short-circuit ratio index, the second short-circuit ratio index and the CSCR and by using the preset voltage support strength estimation rule. The disclosure proposes a practical method for calculating the CSCR, by constructing accurate and practical short-circuit ratio indexes, and provides an accurate, rapid, intuitive and practical method and system for estimating the voltage support strength of the renewable energy grid-connected power system, by taking the CSCR as a reference point and taking the short-circuit ratio of the system as a coordinate. Therefore, the disclosure may estimate the voltage support strength of the renewable energy grid-connected power system more intuitively and simply with characteristics of accuracy and rapidity, and the method is simple and practical, which are of great significance to ensure a safe and stable operation of the renewable energy grid-connected power system.

**Claims**

1. A method for estimating a voltage support strength of a renewable energy grid-connected power system,

   **characterised in that**
   the method comprises:
   determining (101) a first short-circuit ratio index of the renewable energy grid-connected power system based on a short-circuit capacity provided for a grid connection point by an alternating-current, AC, system in the renewable energy grid-connected power system and an equivalent grid connection capacity of a renewable energy at the grid connection point;
   determining (102) a second short-circuit ratio index of the renewable energy grid-connected power system based on a voltage variation at a position where the renewable energy is connected to the grid connection point;
   determining (103) a critical short-circuit ratio, CSCR, of the renewable energy grid-connected power system based on parameters of the AC system and an equivalent maximum transmission power transmitted to the AC system by the renewable energy, wherein the CSCR is a short-circuit ratio corresponding to a critical stable state of the renewable energy grid-connected power system; and
   determining (104) a voltage support strength provided by the renewable energy grid-connected power system at the grid connection point based on the first short-circuit ratio index, the second short-circuit ratio index and the CSCR and by using a preset voltage support strength estimation rule, comprising:

determining an extreme value of the CSCR of the renewable energy grid-connected power system when active power and reactive power of the renewable energy grid-connected power system flow from the renewable energy into the AC system;

determining the extreme value of the CSCR as a standard for dividing strong and weak voltage support levels of the renewable energy grid-connected power system;

determining the strong voltage support level of the renewable energy grid-connected power system when the first short-circuit ratio index or the second short-circuit ratio index is greater than the extreme value of the CSCR; and

determining the weak voltage support level of the renewable energy grid-connected power system when the first short-circuit ratio index or the second short-circuit ratio index is less than the extreme value of the CSCR.

2. The method of claim 1, wherein before determining (101) the first short-circuit ratio index of the renewable energy grid-connected power system based on the short-circuit capacity provided for the grid connection point by the AC system in the renewable energy grid-connected power system and the equivalent grid connection capacity of the renewable energy at the grid connection point, the method comprises:

determining the short-circuit capacity provided for the grid connection point by the AC system in the renewable energy grid-connected power system; and

determining the equivalent grid connection capacity of the renewable energy at the grid connection point.

3. The method of claim 2, wherein the short-circuit capacity provided for the grid connection point by the AC system is calculated by a formula:

$$\dot{S}_{\mathrm{ac},i} = \frac{U_{\mathrm{N}} \dot{E}_{\mathrm{eq},i}}{\dot{Z}_{ii}}$$

wherein $\dot{E}_{\mathrm{eq},i}$ is a no-load operation open-circuit voltage of a grid connection point i before total loads in the AC system are not be considered and the renewable energy is grid-connected; $\dot{Z}_{ii}$ is a diagonal element in an impedance matrix of the grid connection point, which is an equivalent impedance of the AC system to the grid connection point i; and $U_{N}$ is a nominal voltage of the grid connection point i.

4. The method of claim 2, wherein the equivalent grid connection capacity at the grid connection point is calculated by a formula:

$$\dot{S}_{\mathrm{eq},i} = \dot{U}_{i} \dot{I}_{\mathrm{eq},i}^{*} = \dot{S}_{i} + \sum_{j \neq i} \frac{\dot{Z}_{ij}^{*}}{\dot{Z}_{ii}^{*}} \frac{\dot{U}_{i}}{\dot{U}_{j}} \dot{S}_{j}$$

wherein * represents a conjugate operation; $\dot{S}_{i}$, $\dot{S}_{j}$ are capacities of renewable energies directly connected to grid connection points i and j; $I_{\mathrm{eq},i}$ is a line current of the grid connection point i; $\dot{Z}_{ij}$ is a non-diagonal element in an impedance matrix of the grid connection point, which reflects an electrical distance between the grid connection points i and j; $\dot{Z}_{ii}$ is a diagonal element in the impedance matrix of the grid connection point, which is an equivalent impedance of the AC system to the grid connection point i; and $\dot{U}_{i}$, $\dot{U}_{j}$ are node voltages of the grid connection points i and j.

5. The method of claim 2, wherein the first short-circuit ratio index of the renewable energy grid-connected power system is calculated by a formula:

$$\mathrm{SCR\text{-}S}_{i} = \frac{\dot{S}_{\mathrm{ac},i}}{\dot{S}_{\mathrm{eq},i}} = \frac{\left| U_{\mathrm{N}} \dot{E}_{\mathrm{eq},i} / \dot{Z}_{ii} \right|}{\left| \dot{S}_{i} + \sum_{j \neq i} \frac{\dot{Z}_{ij}^{*}}{\dot{Z}_{ii}^{*}} \frac{\dot{U}_{i}}{\dot{U}_{j}} \dot{S}_{j} \right|}$$

wherein SCR-S$_{i}$ is the first short-circuit ratio index of the renewable energy grid-connected power system; $\dot{S}_{\mathrm{ac},i}$ is a short-circuit capacity provided for a grid connection point i by the AC system; $\dot{S}_{\mathrm{eq},i}$ is an equivalent grid connection capacity of the renewable energy at the grid connection point i; $\dot{U}_i$, $\dot{U}_j$ are node voltages of grid connection points i and j; $U_N$ is a nominal voltage of the grid connection point i; $\dot{E}_{eq,i}$ is a no-load operation open-circuit voltage of the grid connection point i before total loads in the AC system are not be considered and the renewable energy is grid-connected; $\dot{Z}_{ii}$ is a diagonal element in an impedance matrix of the grid connection point, which is an equivalent impedance of the AC system to the grid connection point i; $\dot{Z}_{ij}$ is a non-diagonal element in the impedance matrix of the grid connection point, which reflects an electrical distance between the grid connection points i and j; and $\dot{S}_i$, $\dot{S}_j$ are capacities of renewable energies directly connected to the grid connection points i and j.

6. The method of claim 1, wherein determining (102) the second short-circuit ratio index of the renewable energy grid-connected power system based on the voltage variation at the position where the renewable energy is connected to the grid connection point comprises:

   determining a voltage order-reduction equation of the grid connection point when the renewable energy is connected to the grid connection point, wherein the voltage order-reduction equation of the grid connection point is:

$$\begin{bmatrix} \Delta \dot{U}_1 \\ \vdots \\ \Delta \dot{U}_i \\ \vdots \\ \Delta \dot{U}_m \end{bmatrix} = \begin{bmatrix} \dot{Z}_{11} & \cdots & \dot{Z}_{1i} & \cdots & \dot{Z}_{1m} \\ & \vdots & & \vdots & & \vdots \\ \dot{Z}_{i1} & \cdots & \dot{Z}_{ii} & \cdots & \dot{Z}_{im} \\ & \vdots & & \vdots & & \vdots \\ \dot{Z}_{m1} & \cdots & \dot{Z}_{mi} & \cdots & \dot{Z}_{mm} \end{bmatrix} \begin{bmatrix} \dot{I}_{E,1} \\ \vdots \\ \dot{I}_{E,i} \\ \vdots \\ \dot{I}_{E,m} \end{bmatrix}$$

   wherein $\dot{Z}$ is an impedance matrix of the grid connection point; $\Delta \dot{U}$ is a voltage variation at the grid connection point caused when the renewable energy is grid-connected; $\dot{I}_E$ is a current injected by the renewable energy into the grid connection point; and m is a serial number of the grid connection point;
   determining the voltage variation at the position where the renewable energy is connected to the grid connection point based on the voltage order-reduction equation;
   determining a nominal voltage of the grid connection point; and
   determining the second short-circuit ratio index of the renewable energy grid-connected power system based on the voltage variation and the nominal voltage.

7. The method of claim 6, wherein the voltage variation at the position where the renewable energy is connected to the grid connection point is calculated by a formula:

$$\Delta \dot{U}_i = \dot{Z}_{ii} \dot{I}_{E,i} + \sum_{j \neq i} \dot{Z}_{ij} \dot{I}_{E,j}$$

   wherein $\Delta \dot{U}_i$ is a voltage variation of the grid connection point i; $\dot{I}_{E,i}$, $\dot{I}_{E,j}$ are currents injected by the renewable energy into grid connection points i, j; $\dot{Z}_{ii}$ is a diagonal element in an impedance matrix of the grid connection point, which is an equivalent impedance of the AC system to the grid connection point i; and $\dot{Z}_{ij}$ is a non-diagonal element in the impedance matrix of the grid connection point, which reflects an electrical distance between the grid connection points i and j.

8. The method of claim 7, wherein determining (102) the second short-circuit ratio index of the renewable energy grid-connected power system based on the voltage variation and the nominal voltage comprises:

   determining a formula of calculating a ratio of the nominal voltage to the voltage variation; and
   determining the second short-circuit ratio index of the renewable energy grid-connected power system based on the formula of calculating the ratio of the nominal voltage to the voltage variation,
   wherein the ratio of the nominal voltage to the voltage variation is calculated by a formula:

$$\frac{|U_N|}{|\Delta \dot{U}_i|} = \frac{|U_N|}{\left| \dot{Z}_{ii} \dot{I}_{E,i} + \sum_{j \neq i} \dot{Z}_{ij} \dot{I}_{E,j} \right|}$$

wherein $U_N$ is a nominal voltage of the grid connection point i; $\Delta \dot{U}_i$ is the voltage variation of the grid connection point i; $\dot{I}_{E,i}$, $\dot{I}_{E,j}$ are the currents injected by the renewable energy into the grid connection points i, j; $\dot{Z}_{ii}$ is the diagonal element in the impedance matrix of the grid connection point, which is the equivalent impedance of the AC system to the grid connection point i; and $\dot{Z}_{ij}$ is the non-diagonal element in the impedance matrix of the grid connection point, which reflects the electrical distance between the grid connection points i and j,
the second short-circuit ratio index of the renewable energy grid-connected power system is calculated by a formula:

$$\text{SCR-U}_i = \frac{|U_N \dot{E}_{eq,i}|}{|\Delta \dot{U}_i \dot{U}_i|}$$

wherein SCR-$U_i$ is the second short-circuit ratio index of the renewable energy grid-connected power system; $U_N$ is the nominal voltage of the grid connection point i; $\dot{E}_{eq,i}$ is a no-load operation open-circuit voltage of the grid connection point i before total loads in the AC system are not considered and the renewable energy is grid-connected; $\Delta \dot{U}_i$ is the voltage variation of the grid connection point i; and $\dot{U}_i$ is a node voltage of the grid connection point i.

9. The method of claim 1, wherein determining (103) the CSCR of the renewable energy grid-connected power system based on parameters of the AC system and the equivalent maximum transmission power transmitted to the AC system by the renewable energy comprises:

determining a transmission power transmitted to the AC system by the renewable energy, wherein the transmission power is calculated by a formula:

$$\dot{S}_{eq,i} = (U_i \cos\theta_i + jU_i \sin\theta_i)(\frac{U_i \cos\theta_i + jU_i \sin\theta_i - E_{eq,i}}{R_{eq,i} + jX_{eq,i}})^*$$

$$\begin{cases} P_{eq,i} = \dfrac{U_i^2 R_{eq,i} - U_i E_{eq,i} R_{eq,i} \cos\theta_i + U_i E_{eq,i} X_{eq,i} \sin\theta_i}{R_{eq,i}^2 + X_{eq,i}^2} \\ Q_{eq,i} = \dfrac{U_i^2 X_{eq,i} - U_i E_{eq,i} X_{eq,i} \cos\theta_i - U_i E_{eq,i} R_{eq,i} \sin\theta_i}{R_{eq,i}^2 + X_{eq,i}^2} \end{cases}$$

wherein $\dot{S}_{eq,i}$ is an equivalent grid connection capacity of the renewable energy at a grid connection point i; $P_{eq,i}$, $Q_{eq,i}$ are an equivalent active power and an equivalent reactive power transmitted to the AC system by the renewable energy respectively; $E_{eq,i}$ is an equivalent potential of the AC system; $R_{eq,i}$ is a Thevenin equivalent resistance of the AC system, and $X_{eq,i}$ is a Thevenin equivalent reactance of the AC system; $U_i$ is a bus voltage of grid connection of the renewable energy; $\theta_i$ is a difference between a phase angle of the bus voltage and a phase angle of the equivalent potential; and j is an imaginary number;
establishing a one-variable quadratic equation about $U_i^2$ according to a trigonometric function $\sin^2\theta_i + \cos^2\theta_i = 1$:

$$U_i^4 - [2(P_{eq,i} R_{eq,i} + Q_{eq,i} X_{eq,i}) + E_{eq,i}^2]U_i^2 + (R_{eq,i}^2 + X_{eq,i}^2)(P_{eq,i}^2 + Q_{eq,i}^2) = 0$$

$$\begin{cases} \lambda = \dfrac{R_{eq,i} P_{eq,i} + X_{eq,i} Q_{eq,i}}{E^2_{eq,i}} \\[3mm] \mu = \dfrac{X_{eq,i} P_{eq,i} - R_{eq,i} Q_{eq,i}}{E^2_{eq,i}} \end{cases}$$

$$\Delta = 1 + 4(\lambda - \mu^2) = 0$$

wherein $\lambda$, $\mu$ are sensitivity factors, and $\Delta$ is a discriminant of the equation;

setting the transmission power transmitted to the AC system by the renewable energy to be the equivalent maximum transmission power when $\Delta=0$, wherein the equivalent maximum transmission power is calculated by a formula:

$$P_{eq,i\max} = \frac{R_{eq,i}\left(E^2_{eq,i} + 2Q_{eq,i} X_{eq,i}\right) + E_{eq,i}\sqrt{R^2_{eq,i} + X^2_{eq,i}}\sqrt{E^2_{eq,i} + 4Q_{eq,i} X_{eq,i}}}{2X^2_{eq,i}}$$

wherein $P_{eq,i\max}$ is the equivalent maximum transmission power transmitted to the AC system by the renewable energy, $Q_{eq,i}$ is the equivalent reactive power transmitted to the AC system by the renewable energy, $E_{eq,i}$ is the equivalent potential of the AC system; $R_{eq,i}$ is the Thevenin equivalent resistance of the AC system, and $X_{eq,i}$ is the Thevenin equivalent reactance of the AC system; and

determining the CSCR of the renewable energy grid-connected power system, by:

$$CSCR = \frac{\dot{S}_{ac,i}}{\left| P_{eq,i\max} + jQ_{eq,i} \right|}$$

wherein $\dot{S}_{ac,i}$ is a short-circuit capacity provided for the grid connection point i by the AC system; $Q_{eq,i}$ is the equivalent reactive power transmitted to the AC system by the renewable energy; $P_{eq,i\max}$ is the equivalent maximum transmission power transmitted to the AC system by the renewable energy; and j is the imaginary number.

10. The method of claim 1, further comprising: determining a stable state of the renewable energy grid-connected power system based on the first short-circuit ratio index, the second short-circuit ratio index and the CSCR.

11. The method of claim 10, wherein determining the stable state of the renewable energy grid-connected power system based on the first short-circuit ratio index, the second short-circuit ratio index and the CSCR comprises:

determining that the renewable energy grid-connected power system operates in a stable region of P-V characteristics and the renewable energy grid-connected power system is in a stable state, when the first short-circuit ratio index or the second short-circuit ratio index is greater than the CSCR; and

determining that the renewable energy grid-connected power system operates in an unstable region of the P-V characteristics and the renewable energy grid-connected power system is in an unstable state, when the first short-circuit ratio index or the second short-circuit ratio index is less than the CSCR.

12. A computer-readable storage medium, having stored thereon a computer program, the computer program executing the method of any one of claims 1 to 11.

13. An electronic device, comprising:

a processor (41); and

a memory (42) configured to store an executable instruction of the processor (41),

the processor (41) configured to read the executable instruction from the memory (42) and execute the instruction to implement the method of any one of claims 1 to 11.

**Patentansprüche**

1.  Verfahren zum Abschätzen der Spannungsstützstärke eines netzangeschlossenen Stromversorgungssystems für erneuerbare Energien,
    **dadurch gekennzeichnet, dass** das Verfahren umfasst:

    Bestimmen (101) eines ersten Kurzschlussverhältnisindex des netzangeschlossenen Stromversorgungssystems für erneuerbare Energien basierend auf einer Kurzschlusskapazität, die für einen Netzanschlusspunkt durch ein Wechselstromsystem, AC-System, in dem netzangeschlossenen Stromversorgungssystem für erneuerbare Energien bereitgestellt wird, und einer äquivalenten Netzanschlusskapazität einer erneuerbaren Energie an dem Netzanschlusspunkt;
    Bestimmen (102) eines zweiten Kurzschlussverhältnisindex des netzangeschlossenen Stromversorgungssystems für erneuerbare Energien basierend auf einer Spannungsschwankung an einer Position, an der die erneuerbare Energie an den Netzanschlusspunkt angeschlossen ist;
    Bestimmen (103) eines kritischen Kurzschlussverhältnisses, CSCR, des netzangeschlossenen Stromversorgungssystems für erneuerbare Energien basierend auf Parametern des AC-Systems und einer äquivalenten maximalen Übertragungsleistung, die durch die erneuerbare Energie an das AC-System übertragen wird, wobei das CSCR ein Kurzschlussverhältnis ist, das einem kritischen stabilen Zustand des netzangeschlossenen Stromversorgungssystems für erneuerbare Energien entspricht; und
    Bestimmen (104) einer Spannungsstützstärke, die durch das netzangeschlossene Stromversorgungssystem für erneuerbare Energien an dem Netzanschlusspunkt bereitgestellt wird, basierend auf dem ersten Kurzschlussverhältnisindex, dem zweiten Kurzschlussverhältnisindex und dem CSCR und durch Verwenden einer voreingestellten Schätzungsregel der Spannungsstützstärke, umfassend:

    Bestimmen eines Extremwerts des CSCR des netzangeschlossenen Stromversorgungssystems für erneuerbare Energien, wenn eine Wirkleistung und eine Blindleistung des netzangeschlossenen Stromversorgungssystems für erneuerbare Energien von der erneuerbaren Energie in das AC-System fließen;
    Bestimmen des Extremwerts des CSCR als einen Standard zum Aufteilen der Stützpegel starker und schwacher Spannung des netzangeschlossenen Stromversorgungssystems für erneuerbare Energien;
    Bestimmen des Stützpegels starker Spannung des netzangeschlossenen Stromversorgungssystems für erneuerbare Energien, wenn der erste Kurzschlussverhältnisindex oder der zweite Kurzschlussverhältnisindex größer als der Extremwert des CSCR ist; und
    Bestimmen des Stützpegels schwacher Spannung des netzangeschlossenen Stromversorgungssystems für erneuerbare Energien, wenn der erste Kurzschlussverhältnisindex oder der zweite Kurzschlussverhältnisindex kleiner als der Extremwert des CSCR ist.

2.  Verfahren nach Anspruch 1, wobei vor dem Bestimmen (101) des ersten Kurzschlussverhältnisindex des netzangeschlossenen Stromversorgungssystems für erneuerbare Energien basierend auf der Kurzschlusskapazität, die für den Netzanschlusspunkt durch das AC-System in dem netzangeschlossenen Stromversorgungssystem für erneuerbare Energien bereitgestellt wird, und der äquivalenten Netzanschlusskapazität der erneuerbaren Energie an dem Netzanschlusspunkt, das Verfahren umfasst:

    Bestimmen der Kurzschlusskapazität, die für den Netzanschlusspunkt durch das AC-System in dem netzangeschlossenen Stromversorgungssystem für erneuerbare Energien bereitgestellt wird; und
    Bestimmen der äquivalenten Netzanschlusskapazität der erneuerbaren Energie an dem Netzanschlusspunkt.

3.  Verfahren nach Anspruch 2, wobei die Kurzschlusskapazität, die für den Netzanschlusspunkt durch das AC-System bereitgestellt wird, durch eine Formel berechnet wird:

$$\dot{S}_{AC,i} = \frac{U_N \dot{E}_{Gl,i}}{\dot{Z}_{ii}}$$

wobei $\dot{E}_{Gl,i}$ eine Leerlaufspannung eines Netzanschlusspunkts i ist, bevor die Gesamtlasten in dem AC-System nicht berücksichtigt werden sollen und die erneuerbare Energie netzangeschlossen ist; $\dot{Z}_{ii}$ ein diagonales Element in einer Impedanzmatrix des Netzanschlusspunkts ist, das eine äquivalente Impedanz des AC-Systems zu dem Netzanschlusspunkt i ist; und $U_N$ eine Nennspannung des Netzanschlusspunkts i ist.

4. Verfahren nach Anspruch 2, wobei die äquivalente Netzanschlusskapazität an dem Netzanschlusspunkt durch eine Formel berechnet wird:

$$\dot{S}_{Gl,i} = \dot{U}_i I_{Gl,i}^* = \dot{S}_i + \sum_{j \neq i} \frac{\dot{Z}_{ij}^*}{\dot{Z}_{ii}^*} \frac{\dot{U}_i}{\dot{U}_i} \dot{S}_j$$

wobei * eine konjugierte Operation darstellt; $\dot{S}_i$, $\dot{S}_j$ Kapazitäten erneuerbarer Energien sind, die an den Netzanschlusspunkten i und j direkt angeschlossen sind; $I_{Gl,i}$ ein Leitungsstrom des Netzanschlusspunkts i ist; $\dot{Z}_{ij}$ ein nichtdiagonales Element in einer Impedanzmatrix des Netzanschlusspunkts ist, das einen elektrischen Abstand zwischen den Netzanschlusspunkten i und j widerspiegelt; $\dot{Z}_{ii}$ ein diagonales Element in der Impedanzmatrix des Netzanschlusspunkts ist, das eine äquivalente Impedanz des AC-Systems zu dem Netzanschlusspunkt i ist; und $\dot{U}_i$, $\dot{U}_j$ Knotenspannungen der Netzanschlusspunkte i und j sind.

5. Verfahren nach Anspruch 2, wobei der erste Kurzschlussverhältnisindex des netzangeschlossenen Stromversorgungssystems für erneuerbare Energien durch eine Formel berechnet wird:

$$SCR - S_i = \frac{\dot{S}_{Gl,i}}{\dot{S}_{Gl,i}} = \frac{\left| U_N \dot{E}_{Gl,i} / \dot{Z}_{ii} \right|}{\left| \dot{S}_i + \sum_{j \neq i} \frac{\dot{Z}_{ij}^*}{\dot{Z}_{ii}^*} \frac{\dot{U}_i}{\dot{U}_i} \dot{S}_j \right|}$$

wobei SCR-$S_i$ der erste Kurzschlussverhältnisindex des netzangeschlossenen Stromversorgungssystems für erneuerbare Energien ist; $\dot{S}_{Gl,i}$ eine Kurzschlusskapazität ist, die für einen Netzanschlusspunkt i durch das AC-System bereitgestellt wird; $\dot{S}_{Gl,i}$ eine äquivalente Netzanschlusskapazität der erneuerbaren Energie an dem Netzanschlusspunkt i ist; $\dot{U}_i$, $\dot{U}_j$ Knotenspannungen der Netzanschlusspunkte i und j sind; $U_N$ eine Nennspannung des Netzanschlusspunkts i ist; $\dot{E}_{Gl,i}$ eine Leerlaufspannung des Netzanschlusspunkts i ist, bevor die Gesamtlasten in dem AC-System nicht berücksichtigt werden sollen und die erneuerbare Energie netzangeschlossen ist; $\dot{Z}_{ii}$ ein diagonales Element in einer Impedanzmatrix des Netzanschlusspunkts ist, das eine äquivalente Impedanz des AC-Systems zu dem Netzanschlusspunkt i ist; $\dot{Z}_{ij}$ ein nichtdiagonales Element in der Impedanzmatrix des Netzanschlusspunkts ist, das ein elektrischer Abstand zwischen den Netzanschlusspunkten i und j widerspiegelt; und $\dot{S}_i$, $\dot{S}_j$ Kapazitäten erneuerbarer Energien sind, die an den Netzanschlusspunkten i und j direkt angeschlossen sind.

6. Verfahren nach Anspruch 1, wobei das Bestimmen (102) des zweiten Kurzschlussverhältnisindex des netzangeschlossenen Stromversorgungssystems für erneuerbare Energien basierend auf der Spannungsschwankung an der Position, an der die erneuerbare Energie an den Netzanschlusspunkt angeschlossen ist, umfasst:

Bestimmen einer Spannungsordnungsreduktionsgleichung des Netzanschlusspunkts, wenn die erneuerbare Energie an den Netzanschlusspunkt angeschlossen ist, wobei die Spannungsordnungsreduktionsgleichung des Netzanschlusspunkts lautet:

$$\begin{bmatrix} \Delta \dot{U}_1 \\ \vdots \\ \Delta \dot{U}_i \\ \vdots \\ \Delta \dot{U}_m \end{bmatrix} = \begin{bmatrix} \dot{Z}_{11} & \cdots & \dot{Z}_{1i} & \cdots & \dot{Z}_{1m} \\ \vdots & & \vdots & & \vdots \\ \dot{Z}_{i1} & \cdots & \dot{Z}_{ii} & \cdots & \dot{Z}_{im} \\ \vdots & & \vdots & & \vdots \\ \dot{Z}_{m1} & \cdots & \dot{Z}_{mi} & \cdots & \dot{Z}_{mm} \end{bmatrix} \begin{bmatrix} \dot{I}_{E,1} \\ \vdots \\ \dot{I}_{E,i} \\ \vdots \\ \dot{I}_{E,m} \end{bmatrix}$$

wobei Z eine Impedanzmatrix des Netzanschlusspunkts ist; $\Delta \dot{U}$ eine Spannungsschwankung an dem Netzanschlusspunkt ist, die verursacht wird, wenn die erneuerbare Energie netzangeschlossen ist; $\dot{I}_E$ ein Strom ist, der durch die erneuerbare Energie in den Netzanschlusspunkt eingespeist wird; und m eine laufende Nummer des Netzanschlusspunkts ist;
Bestimmen der Spannungsschwankung an der Position, an der die erneuerbare Energie mit dem Netzanschlusspunkt angeschlossen wird, basierend auf der Spannungsordnungsreduktionsgleichung;
Bestimmen einer Nennspannung des Netzanschlusspunkts; und
Bestimmen des zweiten Kurzschlussverhältnisindex des netzangeschlossenen Stromversorgungssystems für erneuerbare Energien basierend auf der Spannungsschwankung und der Nennspannung.

**7.** Verfahren nach Anspruch 6, wobei die Spannungsschwankung an der Position, an der die erneuerbare Energie an den Netzanschlusspunkt angeschlossen wird, durch eine Formel berechnet wird:

$$\Delta \dot{U}_i = \dot{Z}_{ii} \dot{I}_{E,i} + \sum_{j \neq i} \dot{Z}_{ij} \dot{I}_{E,j}$$

wobei $\Delta \dot{U}_i$ eine Spannungsschwankung des Netzanschlusspunkts i ist; $\dot{I}_{E,i}$, $\dot{I}_{E,j}$ Ströme sind, die durch die erneuerbare Energie in die Netzanschlusspunkte i, j eingespeist werden; $\dot{Z}_{ii}$ ein diagonales Element in einer Impedanzmatrix des Netzanschlusspunkts ist, das eine äquivalente Impedanz des AC-Systems zu dem Netzanschlusspunkt i ist; und $\dot{Z}_{ij}$ ein nichtdiagonales Element in der Impedanzmatrix des Netzanschlusspunkts ist, das einen elektrische Abstand zwischen den Netzanschlusspunkten i und j widerspiegelt.

**8.** Verfahren nach Anspruch 7, wobei das Bestimmen (102) des zweiten Kurzschlussverhältnisindex des netzangeschlossenen Stromversorgungssystems für erneuerbare Energien basierend auf der Spannungsschwankung und der Nennspannung umfasst:

Bestimmen einer Formel zum Berechnen eines Verhältnisses der Nennspannung zu der Spannungsschwankung; und
Bestimmen des zweiten Kurzschlussverhältnisindex des netzangeschlossenen Stromversorgungssystems für erneuerbare Energien basierend auf der Formel zum Berechnen des Verhältnisses der Nennspannung zu der Spannungsschwankung,
wobei das Verhältnis der Nennspannung zu der Spannungsschwankung durch eine Formel berechnet wird:

$$\frac{|U_N|}{|\Delta \dot{U}_i|} = \frac{|U_N|}{\left| \dot{Z}_{ii} \dot{I}_{E,i} + \sum_{j \neq i} \dot{Z}_{ij} \dot{I}_{E,j} \right|}$$

wobei $U_N$ eine Nennspannung des Netzanschlusspunkts i ist; $\Delta \dot{U}_i$ die Spannungsschwankung des Netzanschlusspunkts i ist; $\dot{I}_{E,i}$, $\dot{I}_{E,j}$ die Ströme sind, die durch die erneuerbare Energie in die Netzanschlusspunkte i, j eingespeist werden; $\dot{Z}_{ii}$ das diagonale Element in der Impedanzmatrix des Netzanschlusspunkts ist, das die äquivalente Impedanz des AC-Systems zu dem Netzanschlusspunkt i ist; und $\dot{Z}_{ij}$ das nichtdiagonale Element in der Impedanzmatrix des Netzanschlusspunkts ist, das den elektrischen Abstand zwischen den Netzanschlusspunkten i und j widerspiegelt,
der zweite Kurzschlussverhältnisindex des netzangeschlossenen Stromversorgungssystems für erneuerbare Energien durch eine Formel berechnet wird:

$$SCR - U_i = \frac{|U_N \dot{E}_{Gl,i}|}{|\Delta \dot{U}_i \dot{U}_i|}$$

wobei SCR-$U_i$ der zweite Kurzschlussverhältnisindex des netzangeschlossenen Stromversorgungssystems für erneuerbare Energien ist; $U_N$ die Nennspannung des Netzanschlusspunkts i ist; $\dot{E}_{Gl,i}$ eine Leerlaufspannung des Netzanschlusspunkts i ist, bevor die Gesamtlasten in dem AC-System nicht berücksichtigt werden und die erneuerbare Energie netzangeschlossen ist; $\Delta \dot{U}_i$ die Spannungsschwankung des Netzanschlusspunkts i ist; und $\dot{U}_i$ eine Knotenspannung des Netzanschlusspunkts i ist.

**9.** Verfahren nach Anspruch 1, wobei das Bestimmen (103) des CSCR des netzangeschlossenen Stromversorgungssystems für erneuerbare Energien basierend auf Parametern des AC-Systems und der äquivalenten maximalen Übertragungsleistung, die durch die erneuerbare Energie an das AC-System übertragen wird, umfasst:

Bestimmen einer Übertragungsleistung, die durch die erneuerbare Energie an das AC-System übertragen wird, wobei die Übertragungsleistung durch eine Formel berechnet wird:

$$\dot{S}_{Gl,i} = (U_i cos\theta_i + jU_i sin\theta_i)\left(\frac{U_i cos\theta_i + jU_i sin\theta_i - E_{Gl,i}}{R_{Gl,i} + jX_{Gl,i}}\right)^*$$

$$\begin{cases} P_{Gl,i} = \dfrac{U_i^2 R_{Gl,i} - U_i E_{Gl,i} R_{Gl,i} cos\theta_i + U_i E_{Gl,i} X_{Gl,i} sin\theta_i}{R_{Gl,i}^2 + X_{Gl,i}^2} \\[3mm] Q_{Gl,i} = \dfrac{U_i^2 X_{Gl,i} - U_i E_{Gl,i} X_{Gl,i} cos\theta_i - U_i E_{Gl,i} R_{Gl,i} sin\theta_i}{R_{Gl,i}^2 + X_{Gl,i}^2} \end{cases}$$

wobei $\dot{S}_{Gl,i}$ eine äquivalente Netzanschlusskapazität der erneuerbaren Energie an einem Netzanschlusspunkt i ist; $P_{Gl,i}$, $Q_{Gl,i}$ eine äquivalente Wirkleistung und eine äquivalente Blindleistung sind, die durch die erneuerbare Energie an das AC-System übertragen werden; $E_{Gl,i}$ ein äquivalentes Potenzial des AC-Systems ist; $R_{Gl,i}$ ein Thevenin-Äquivalentwiderstand des AC-Systems ist und $X_{Gl,i}$ eine Thevenin-äquivalente Reaktanz des AC-Systems ist; $U_i$ eine Busspannung des Netzanschlusses der erneuerbaren Energie ist; $\theta_i$ eine Differenz zwischen einem Phasenwinkel der Busspannung und einem Phasenwinkel des äquivalenten Potenzials ist; und j eine imaginäre Zahl ist;

Aufstellen einer quadratischen Gleichung mit einer Variablen über $U_i^2$ gemäß einer trigonometrischen Funktion $sin^2\theta_i + cos^2\theta_i = 1$:

$$U_i^4 - \left[2\left(P_{Gl,i}R_{Gl,i} + Q_{Gl,i}X_{Gl,i}\right) + E_{Gl,i}^2\right]U_i^2 + \left(R_{Gl,i}^2 + X_{Gl,i}^2\right)\left(P_{Gl,i}^2 + Q_{Gl,i}^2\right) = 0$$

$$\begin{cases} \lambda = \dfrac{R_{Gl,i}P_{Gl,i} + X_{Gl,i}Q_{Gl,i}}{E_{Gl,i}^2} \\[3mm] \mu = \lambda = \dfrac{X_{Gl,i}P_{Gl,i} - R_{Gl,i}Q_{Gl,i}}{E_{Gl,i}^2} \end{cases}$$

$$\Delta = 1 + 4(\lambda - \mu^2) = 0$$

wobei $\lambda$ und $\mu$ Sensitivitätsfaktoren sind und $\Delta$ eine Diskriminante der Gleichung ist;

Festlegen der Übertragungsleistung, die durch die erneuerbare Energie an das AC-System übertragen wird, um die äquivalente maximale Übertragungsleistung zu sein, wenn $\Delta=0$, wobei die äquivalente maximale Übertragungsleistung durch eine Formel berechnet wird:

$$P_{Gl,i\,max} = \frac{R_{Gl,i}\left(E_{Gl,i}^2 + 2Q_{Gl,i}X_{Gl,i}\right) + E_{Gl,i}\sqrt{R_{Gl,i}^2 + X_{Gl,i}^2}\sqrt{E_{Gl,i}^2 + 4Q_{Gl,i}X_{Gl,i}}}{2X_{Gl,i}^2}$$

wobei $P_{Gl,imax}$ die äquivalente maximale Übertragungsleistung ist, die durch die erneuerbare Energie an das AC-System übertragen wird, $Q_{Gl,i}$ die äquivalente Blindleistung ist, die durch die erneuerbare Energie an das AC-System übertragen wird, $E_{Gl,i}$ das äquivalente Potenzial des AC-Systems ist; $R_{Gl,i}$ der Thevenin-Äquivalentwiderstand des AC-Systems ist und $X_{Gl,i}$ die Thevenin-äquivalente Reaktanz des AC-Systems ist; und

Bestimmen des CSCR des netzangeschlossenen Stromversorgungssystems für erneuerbare Energien durch:

$$CSCR = \frac{\dot{S}_{AC,i}}{\left|P_{Gl,i\,max} + jQ_{Gl,i}\right|}$$

wobei $\dot{S}_{GI,i}$ eine Kurzschlusskapazität ist, die durch das AC-System für den Netzanschlusspunkt i bereitgestellt wird; $Q_{GI,i}$ die äquivalente Blindleistung ist, die durch die erneuerbaren Energie an das AC-System übertragen wird; $P_{GI,i\text{max}}$ die äquivalente maximale Übertragungsleistung ist, die durch die erneuerbare Energie an das AC-System übertragen wird; und j die imaginäre Zahl ist.

10. Verfahren nach Anspruch 1, ferner umfassend: Bestimmen eines stabilen Zustands des netzangeschlossenen Stromversorgungssystems für erneuerbare Energien basierend auf dem ersten Kurzschlussverhältnisindex, dem zweiten Kurzschlussverhältnisindex und dem CSCR.

11. Verfahren nach Anspruch 10, wobei das Bestimmen des stabilen Zustands des netzangeschlossenen Stromversorgungssystems für erneuerbare Energien basierend auf dem ersten Kurzschlussverhältnisindex, dem zweiten Kurzschlussverhältnisindex und dem CSCR umfasst:

Bestimmen, dass das netzangeschlossene Stromversorgungssystem für erneuerbare Energien in einem stabilen Bereich von P-V-Eigenschaften betrieben wird und sich das netzangeschlossene Stromversorgungssystem für erneuerbare Energien in einem stabilen Zustand befindet, wenn der erste Kurzschlussverhältnisindex oder der zweite Kurzschlussverhältnisindex größer als das CSCR ist; und
Bestimmen, dass das netzangeschlossene Stromversorgungssystem für erneuerbare Energien in einem instabilen Bereich der P-V-Eigenschaften betrieben wird und sich das netzangeschlossene Stromversorgungssystem für erneuerbare Energien in einem instabilen Zustand befindet, wenn der erste Kurzschlussverhältnisindex oder der zweite Kurzschlussverhältnisindex kleiner als der CSCR ist.

12. Computerlesbares Speichermedium, das ein Computerprogramm darauf gespeichert aufweist, wobei das Computerprogramm das Verfahren nach einem der Ansprüche 1 bis 11 ausführt.

13. Elektronische Vorrichtung, umfassend:

einen Prozessor (41); und
einen Speicher (42), der konfiguriert ist, um eine ausführbare Anweisung des Prozessors (41) zu speichern, wobei der Prozessor (41) konfiguriert ist, um die ausführbare Anweisung aus dem Speicher (42) zu lesen und die Anweisung auszuführen, um das Verfahren nach einem der Ansprüche 1 bis 11 zu implementieren.

**Revendications**

1. Procédé d'estimation d'une résistance de maintien de tension d'un système électrique à énergie renouvelable connecté au réseau,

**caractérisé en ce que** le procédé comprend
la détermination (101) d'un premier indice de rapport de court-circuit du système électrique à énergie renouvelable connecté au réseau sur la base d'une capacité de court-circuit fournie pour un point de connexion au réseau par un système à courant alternatif, CA, dans le système électrique à énergie renouvelable connecté au réseau et d'une capacité de connexion au réseau équivalente d'une énergie renouvelable au point de connexion au réseau ;
la détermination (102) d'un second indice de rapport de court-circuit du système électrique à énergie renouvelable connecté au réseau sur la base d'une variation de tension à un endroit où l'énergie renouvelable est connectée au point de connexion au réseau ;
la détermination (103) d'un rapport de court-circuit critique, CSCR, du système électrique à énergie renouvelable connecté au réseau sur la base de paramètres du système CA et d'une puissance de transmission maximale équivalente transmise au système CA par l'énergie renouvelable, dans lequel le CSCR est un rapport de court-circuit correspondant à un état stable critique du système électrique à énergie renouvelable connecté au réseau ; et
la détermination (104) d'une capacité de maintien de tension fournie par le système électrique à énergie renouvelable connecté au réseau au point de connexion au réseau sur la base du premier indice de rapport de court-circuit, du second indice de rapport de court-circuit et du CSCR et à l'aide d'une règle d'estimation de la capacité de maintien de tension prédéfinie, comprenant :

la détermination d'une valeur extrême du CSCR du système électrique à énergie renouvelable connecté au réseau lorsque la puissance active et la puissance réactive du système électrique à énergie renouvelable connecté au réseau circulent à partir de l'énergie renouvelable dans le système CA ;

la détermination de la valeur extrême du CSCR en tant que norme pour diviser des niveaux de maintien de tension fort et faible du système électrique à énergie renouvelable connecté au réseau ;

la détermination du niveau de maintien de tension fort du système électrique à énergie renouvelable connecté au réseau lorsque le premier indice de rapport de court-circuit ou le second indice de rapport de court-circuit est supérieur à la valeur extrême du CSCR ; et

la détermination du niveau de maintien de tension faible du système électrique à énergie renouvelable connecté au réseau lorsque le premier indice de rapport de court-circuit ou le second indice de rapport de court-circuit est inférieur à la valeur extrême du CSCR.

2. Procédé selon la revendication 1, dans lequel avant de déterminer (101) le premier indice de rapport de court-circuit du système électrique à énergie renouvelable connecté au réseau sur la base de la capacité de court-circuit fournie pour le point de connexion au réseau par le système CA dans le système électrique à énergie renouvelable connecté au réseau et de la capacité de connexion au réseau équivalente de l'énergie renouvelable au point de connexion au réseau, le procédé comprend :

la détermination de la capacité de court-circuit fournie pour le point de connexion au réseau par le système CA dans le système électrique à énergie renouvelable connecté au réseau ; et

la détermination de la capacité de connexion au réseau équivalente de l'énergie renouvelable au point de connexion au réseau.

3. Procédé selon la revendication 2, dans lequel la capacité de court-circuit fournie pour le point de connexion au réseau par le système CA est calculée par une formule :

$$\dot{S}_{\mathrm{ac},i} = \frac{U_{\mathrm{N}} \dot{E}_{\mathrm{eq},i}}{\dot{Z}_{ii}}$$

où $\dot{E}_{\mathrm{eq},i}$ est une tension à vide en circuit ouvert d'un point de connexion au réseau i avant que des charges totales du système CA ne soient pas prises en compte et que l'énergie renouvelable soit connectée au réseau ; $\dot{Z}_{ii}$ est un élément diagonal d'une matrice d'impédance du point de connexion au réseau, qui est une impédance équivalente du système CA au point de connexion au réseau i ; et $U_N$ est une tension nominale du point de connexion au réseau i.

4. Procédé selon la revendication 2, dans lequel la capacité de connexion au réseau équivalente au point de connexion au réseau est calculée par une formule :

$$\dot{S}_{\mathrm{eq},i} = \dot{U}_i I_{\mathrm{eq},i}^{*} = \dot{S}_i + \sum_{j \neq i} \frac{\dot{Z}_{ij}^{*}}{\dot{Z}_{ii}^{*}} \frac{\dot{U}_i}{\dot{U}_j} \dot{S}_j$$

où * représente une opération conjuguée ; $\dot{S}_i, \dot{S}_j$ sont des capacités des énergies renouvelables directement connectées à des points de connexion au réseau i et j ; $I_{\mathrm{eq},i}$ est un courant de ligne du point de connexion au réseau i ; $\dot{Z}_{ij}$ est un élément non diagonal d'une matrice d'impédance du point de connexion au réseau, qui reflète une distance électrique entre les points de connexion au réseau i et j ; $\dot{Z}_{ii}$ est un élément diagonal de la matrice d'impédance du point de connexion au réseau, qui est une impédance équivalente du système CA au point de connexion au réseau i ; et $\dot{U}_i$, $\dot{U}_j$ sont des tensions de nœud des points de connexion au réseau i et j.

5. Procédé selon la revendication 2, dans lequel le premier indice de rapport de court-circuit du système électrique à énergie renouvelable connecté au réseau est calculé par une formule :

$$\mathrm{SCR\text{-}S}_i = \frac{\dot{S}_{\mathrm{ac},i}}{\dot{S}_{\mathrm{eq},i}} = \frac{\left| U_{\mathrm{N}} \dot{E}_{\mathrm{eq},i} \big/ \dot{Z}_{ii} \right|}{\left| \dot{S}_i + \sum_{j \neq i} \frac{\dot{Z}_{ij}^{*}}{\dot{Z}_{ii}^{*}} \frac{\dot{U}_i}{\dot{U}_j} \dot{S}_j \right|}$$

où SCR-$S_i$ est le premier indice de rapport de court-circuit du système électrique à énergie renouvelable connecté au réseau ; $\dot{S}_{ac,i}$ est une capacité de court-circuit fournie par le système CA pour un point de connexion au réseau i ; $\dot{S}_{eq,i}$ est une capacité de connexion au réseau équivalente de l'énergie renouvelable au point de connexion au réseau i ; $\dot{U}_i$, $\dot{U}_j$ sont des tensions de nœud de points de connexion au réseau i et j ; $U_N$ est une tension nominale du point de connexion au réseau i ; $\dot{E}_{eq,i}$ est une tension à vide en circuit ouvert du point de connexion au réseau i avant que des charges totales du système CA ne soient pas prises en compte et que l'énergie renouvelable soit connectée au réseau ; $\dot{Z}_{ii}$ est un élément diagonal d'une matrice d'impédance du point de connexion au réseau, qui est une impédance équivalente du système CA au point de connexion au réseau i ; $\dot{Z}_{ij}$ est un élément non diagonal de la matrice d'impédance du point de connexion au réseau, qui reflète une distance électrique entre les points de connexion au réseau i et j ; et $\dot{S}_i, \dot{S}_j$ sont des capacités des énergies renouvelables directement connectées à des points de connexion au réseau i et j.

6. Procédé selon la revendication 1, dans lequel la détermination (102) du second indice de rapport de court-circuit du système électrique à énergie renouvelable connecté au réseau sur la base de la variation de tension à l'endroit où l'énergie renouvelable est connectée au point de connexion au réseau comprend :

la détermination d'une équation de réduction d'ordre de tension du point de connexion au réseau lorsque l'énergie renouvelable est connectée au point de connexion au réseau, dans lequel l'équation de réduction d'ordre de tension du point de connexion au réseau est :

$$
\begin{bmatrix} \Delta\dot{U}_1 \\ \vdots \\ \Delta\dot{U}_i \\ \vdots \\ \Delta\dot{U}_m \end{bmatrix} = \begin{bmatrix} \dot{Z}_{11} & \cdots \dot{Z}_{1i} & \cdots \dot{Z}_{1m} \\ \vdots & \vdots & \vdots \\ \dot{Z}_{i1} & \cdots \dot{Z}_{ii} & \cdots \dot{Z}_{im} \\ \vdots & \vdots & \vdots \\ \dot{Z}_{m1} & \cdots \dot{Z}_{mi} & \cdots \dot{Z}_{mm} \end{bmatrix} \begin{bmatrix} \dot{I}_{E,1} \\ \vdots \\ \dot{I}_{E,i} \\ \vdots \\ \dot{I}_{E,m} \end{bmatrix}
$$

où $\dot{Z}$ est une matrice d'impédance du point de connexion au réseau ; $\Delta\dot{U}$ est une variation de tension au point de connexion au réseau provoquée lorsque l'énergie renouvelable est connectée au réseau ; $\dot{I}_E$ est un courant injecté par l'énergie renouvelable dans le point de connexion au réseau ; et m est le numéro de série du point de connexion au réseau ;
la détermination de la variation de tension à l'endroit où l'énergie renouvelable est connectée au point de connexion au réseau sur la base de l'équation de réduction d'ordre de tension ;
la détermination de la tension nominale du point de connexion au réseau ; et
la détermination du second indice de rapport de court-circuit du système électrique à énergie renouvelable connecté au réseau sur la base de la variation de tension et de la tension nominale.

7. Procédé selon la revendication 6, dans lequel la variation de tension à l'endroit où l'énergie renouvelable est connectée au point de connexion au réseau est calculée par une formule :

$$
\Delta\dot{U}_i = \dot{Z}_{ii}\dot{I}_{E,i} + \sum_{j \neq i} \dot{Z}_{ij}\dot{I}_{E,j}
$$

où $\Delta\dot{U}_i$ est une variation de tension du point de connexion au réseau i ; $\dot{I}_{E,i}$, $\dot{I}_{E,j}$ sont des courants injectés par l'énergie renouvelable dans des points de connexion au réseau i, j ; $\dot{Z}_{ii}$ est un élément diagonal d'une matrice d'impédance du point de connexion au réseau, qui est une impédance équivalente du système CA au point de connexion au réseau i ; et $\dot{Z}_{ij}$ est un élément non diagonal de la matrice d'impédance du point de connexion au réseau, qui reflète une distance électrique entre les points de connexion au réseau i et j.

8. Procédé selon la revendication 7, dans lequel la détermination (102) du second indice de rapport de court-circuit du système électrique à énergie renouvelable connecté au réseau sur la base de la variation de tension et de la tension nominale comprend :

la détermination d'une formule de calcul d'un rapport entre la tension nominale et la variation de tension ; et

la détermination du second indice de rapport de court-circuit du système électrique à énergie renouvelable connecté au réseau sur la base de la formule de calcul du rapport entre la tension nominale et la variation de tension,

dans lequel le rapport entre la tension nominale et la variation de tension est calculé par une formule :

$$\frac{|U_N|}{|\Delta \dot{U}_i|} = \frac{|U_N|}{\left| \dot{Z}_{ii} \dot{I}_{E,i} + \sum_{j \neq i} \dot{Z}_{ij} \dot{I}_{E,j} \right|}$$

où $U_N$ est une tension nominale du point de connexion au réseau i ; $\Delta \dot{U}_i$ est la variation de tension du point de connexion au réseau i ; $\dot{I}_{E,i}$, $\dot{I}_{E,j}$ sont les courants injectés par l'énergie renouvelable dans les points de connexion au réseau i, j ; $\dot{Z}_{ii}$ est l'élément diagonal de la matrice d'impédance du point de connexion au réseau, qui est l'impédance équivalente du système CA au point de connexion au réseau i ; et $\dot{Z}_{ij}$ est l'élément non diagonal de la matrice d'impédance du point de connexion au réseau, qui reflète la distance électrique entre les points de connexion au réseau i et j,

le second indice de rapport de court-circuit du système électrique à énergie renouvelable connecté au réseau est calculé par une formule :

$$\text{SCR-}U_i = \frac{\left| U_N \dot{E}_{eq,i} \right|}{\left| \Delta \dot{U}_i \dot{U}_i \right|}$$

où SCR-$U_i$ est le second indice de rapport de court-circuit du système électrique à énergie renouvelable connecté au réseau ; $U_N$ est une tension nominale du point de connexion au réseau i ; $\dot{E}_{eq,i}$ est une tension à vide en circuit ouvert du point de connexion au réseau i avant que des charges totales du système CA ne soient pas prises en compte et que l'énergie renouvelable soit connectée au réseau ; $\Delta \dot{U}_i$ est la variation de tension du point de connexion au réseau i ; et $\dot{U}_i$ est une tension de nœud du point de connexion au réseau i.

9. Procédé selon la revendication 1, dans lequel la détermination (103) du CSCR du système électrique à énergie renouvelable connecté au réseau sur la base de paramètres du système CA et de la puissance de transmission maximale équivalente transmise au système CA par l'énergie renouvelable comprend :

la détermination d'une puissance de transmission transmise au système CA par l'énergie renouvelable, dans lequel la puissance de transmission est calculée par une formule :

$$\dot{S}_{eq,i} = (U_i \cos\theta_i + jU_i \sin\theta_i)(\frac{U_i \cos\theta_i + jU_i \sin\theta_i - E_{eq,i}}{R_{eq,i} + jX_{eq,i}})^*$$

$$\begin{cases} P_{eq,i} = \dfrac{U_i^2 R_{eq,i} - U_i E_{eq,i} R_{eq,i} \cos\theta_i + U_i E_{eq,i} X_{eq,i} \sin\theta_i}{R_{eq,i}^2 + X_{eq,i}^2} \\[2ex] Q_{eq,i} = \dfrac{U_i^2 X_{eq,i} - U_i E_{eq,i} X_{eq,i} \cos\theta_i - U_i E_{eq,i} R_{eq,i} \sin\theta_i}{R_{eq,i}^2 + X_{eq,i}^2} \end{cases}$$

où $\dot{S}_{eq,i}$ est une capacité de connexion au réseau équivalente de l'énergie renouvelable à un point de connexion au réseau i ; $P_{eq,i}$, $Q_{eq,i}$ sont respectivement une puissance active équivalente et une puissance réactive équivalente transmises au système CA par l'énergie renouvelable ; $E_{eq,i}$ est un potentiel équivalent du système CA ; $R_{eq,i}$ est une résistance équivalente de Thevenin du système CA, et $X_{eq,i}$ est une réactance équivalente de Thevenin du système CA ; $U_i$ est une tension de bus de la connexion au réseau de l'énergie renouvelable ; $\theta_i$ est une différence entre un angle de phase de la tension du bus et un angle de phase du potentiel équivalent ; et j est un nombre imaginaire ;

l'établissement d'une équation quadratique à une variable autour de $U_i^2$ selon une fonction trigonométrique $\sin^2\theta_i +\cos^2\theta_i=1$ :

$$U_i^4 - [2(P_{eq,i}R_{eq,i} + Q_{eq,i}X_{eq,i}) + E_{eq,i}^2]U_i^2 + (R_{eq,i}^2 + X_{eq,i}^2)(P_{eq,i}^2 + Q_{eq,i}^2) = 0$$

$$\begin{cases} \lambda = \dfrac{R_{eq,i}P_{eq,i} + X_{eq,i}Q_{eq,i}}{E_{eq,i}^2} \\[3mm] \mu = \dfrac{X_{eq,i}P_{eq,i} - R_{eq,i}Q_{eq,i}}{E_{eq,i}^2} \end{cases}$$

$$\Delta = 1 + 4(\lambda - \mu^2) = 0$$

où $\lambda$, $\mu$ sont des facteurs de sensibilité, et $\Delta$ est un discriminant de l'équation ;

le réglage de la puissance de transmission transmise au système CA par l'énergie renouvelable à la puissance de transmission maximale équivalente lorsque $\Delta=0$, dans lequel la puissance de transmission maximale équivalente est calculée par une formule :

$$P_{eq,i\,max} = \frac{R_{eq,i}\left(E_{eq,i}^2 + 2Q_{eq,i}X_{eq,i}\right) + E_{eq,i}\sqrt{R_{eq,i}^2 + X_{eq,i}^2}\sqrt{E_{eq,i}^2 + 4Q_{eq,i}X_{eq,i}}}{2X_{eq,i}^2}$$

où $P_{eq,imax}$ est la puissance de transmission maximale équivalente transmise au système CA par l'énergie renouvelable, $Q_{eq,i}$ est la puissance réactive équivalente transmise au système CA par l'énergie renouvelable, $E_{eq,i}$ est le potentiel équivalent du système CA ; $R_{eq,i}$ est la résistance équivalente de Thevenin du système CA, et $X_{eq,i}$ est la réactance équivalente de Thevenin du système CA ; et

la détermination du CSCR du système électrique à énergie renouvelable connecté au réseau, par :

$$CSCR = \frac{\dot{S}_{ac,i}}{\left|P_{eq,i\,max} + jQ_{eq,i}\right|}$$

où $\dot{S}_{ac,i}$ est une capacité de court-circuit fournie pour le point de connexion au réseau i par le système CA ; $Q_{eq,i}$ est la puissance réactive équivalente transmise au système CA par l'énergie renouvelable ; $P_{eq,imax}$ est la puissance de transmission maximale équivalente transmise au système CA par l'énergie renouvelable ; et j est le nombre imaginaire.

10. Procédé selon la revendication 1, comprenant en outre : la détermination d'un état stable du système électrique à énergie renouvelable connecté au réseau sur la base du premier indice de rapport de court-circuit, du second indice de rapport de court-circuit et du CSCR.

11. Procédé selon la revendication 10, dans lequel la détermination de l'état stable du système électrique à énergie renouvelable connecté au réseau sur la base du premier indice de rapport de court-circuit, du second indice de rapport de court-circuit et du CSCR comprend :

la détermination que le système électrique à énergie renouvelable connecté au réseau fonctionne dans une région stable de caractéristiques P-V et que le système électrique à énergie renouvelable connecté au réseau est dans un état stable, lorsque le premier indice de rapport de court-circuit ou le second indice de rapport de court-circuit est supérieur au CSCR ; et

la détermination que le système électrique à énergie renouvelable connecté au réseau fonctionne dans une région instable des caractéristiques P-V et que le système électrique à énergie renouvelable connecté au réseau est dans un état instable, lorsque le premier indice de rapport de court-circuit ou le second indice de rapport de court-circuit est inférieur au CSCR.

12. Support de stockage lisible par ordinateur, sur lequel est stocké un programme informatique, le programme informatique exécutant le procédé selon l'une quelconque des revendications 1 à 11.

13. Dispositif électronique, comprenant :

un processeur (41) ; et
une mémoire (42) configurée pour stocker une instruction exécutable du processeur (41),
le processeur (41) étant configuré pour lire l'instruction exécutable à partir de la mémoire (42) et exécuter l'instruction pour mettre en œuvre le procédé selon l'une quelconque des revendications 1 à 11.

101

Determine a first short-circuit ratio index of the renewable energy grid-connected power system based on a short-circuit capacity provided for a grid connection point by an alternating-current (AC) system in the renewable energy grid-connected power system and an equivalent grid connection capacity of a renewable energy at the grid connection point

102

Determine a second short-circuit ratio index of the renewable energy grid-connected power system based on a voltage variation at a position where the renewable energy is connected to the grid connection point

103

Determine a critical short-circuit ratio (CSCR) of the renewable energy grid-connected power system based on parameters of the AC system and an equivalent maximum transmission power transmitted to the AC system by the renewable energy

104

Determine a voltage support strength provided by the renewable energy grid-connected power system at the grid connection point based on the first short-circuit ratio index, the second short-circuit ratio index and the CSCR by using a preset voltage support strength estimation rule

**FIG. 1**

Determine a stable state of a renewable energy grid-connected power system

Critical stability: SCR-U（SCR-S）=CSCR

SCR-U
SCR-S

SCR-U
SCR-S

SCR-U
SCR-S

SCR-U
SCR-S

SCR-U
SCR-S

$CSCR \leqslant CSCR_{max}=2$

Determine strong and weak levels of the renewable energy grid-connected power system

**FIG. 2**

310

First short-circuit ratio index determination module

320

Second short-circuit ratio index determination module

330

CSCR determination module

340

Voltage support strength determination module

**FIG. 3**

FIG. 4

**EP 4 346 049 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111502749

- CN 112564175 A

**Non-patent literature cited in the description**

- **SCHUERGER MATT et al.** Catching Some Rays: Variable Generation Integration on the Island of Oahu. *IEEE POWER AND ENERGY MAGAZINE*, vol. 11, 33-34